# EUROPEAN PATENT APPLICATION

(11) **EP 4 403 408 A1**
(43) Date of publication of application: **24.07.2024**
(21) Application number: 23152150.1
(22) Date of filing: 18.01.2023
(51) Int. Cl.: B60L 58/19, B60L 53/10, B60L 3/00

(54) **BATTERY PACK CONTROL METHOD AND SYSTEM**

(71) Applicant: Polestar Performance AB, 405 31 Göteborg (SE)
(72) Inventor: Klintberg, Anton, 423 63 Torslanda (SE); Norberg, Olof, 417 61 Göteborg (SE); Hageman, Johan Gerard, 411 02 Göteborg (SE); Källvik, Magnus, 449 50 Alafors (SE)
(74) Representative: Zacco Sweden AB

(57) **Abstract**

A control method of a battery pack, wherein the battery pack comprises: a first node (HV+) and a second node (HV-), a first battery string (100) and a second battery string (200), and a plurality of switching elements (SW1, SW2, SW3, SW4, SW5). The method comprises: controlling the plurality of switching elements to open; measuring the respective voltages on each terminal of each of the plurality of switching elements by using a plurality of sensors; determining a status of each of the plurality of switching elements being open or closed; when the switching element SW5 is controlled to close, preventing any of the switching elements SW1 or SW4 from being closed, until determining the status of each of the plurality of switching elements being open; when any of the switching elements SW1 or SW4 is controlled to close, preventing the switching element SW5 from being closed, until determining the status of each of the plurality of switching elements being open.

## Description

### Technical field

The present document relates to a control method and system for a battery pack. In particular, it relates to a safety control method and system for a battery pack of a vehicle, such as an electric vehicle or a hybrid electric vehicle.

### Background

Together with emerging automotive technologies, the electric vehicles (EVs) and hybrid electric vehicles (HEVs) have been researched, developed, and manufactured globally. The EVs and HEVs are vehicles comprising electric motors for propulsion. The EVs and HEVs may include different types of vehicles, such as road and rail vehicles, surface and underwater vehicles, aircrafts, and spacecrafts. The electric motor can be typically powered by electricity from extravehicular sources, e.g., an electric rail train, or be powered by a battery, e.g., an electric car.

The EV/HEV may use electricity stored in rechargeable batteries or rechargeable battery packs for driving the electric motors. At present, a typical charging station charges EVs/HEVs with 400 V DC. In order to increase the charging speed, a larger current may be used. As a consequence, charging cables will need to be thicker and current collectors will need to be stronger to handle the increased amount of current. Since a lightweight and small-sized battery pack is also desired, there is a trend to increase the charging speed by charging with a higher voltage, such as a charging station charging with 800 V DC instead of 400 V DC. Another advantage of charging with 800 V DC is that it is more energy efficient.

Thus, it is desirable to have the battery pack to be compatible with charging stations charging with both 400V DC and 800V DC. One solution is to provide a battery pack having two battery strings which are configurable to be connected in series (for charging with 800V DC) or parallel (for charging with 400V DC). Such a battery pack is known as a switched battery pack. Comparing with a single-string non-switched battery pack, which normally comprises three contactors for connecting to the high voltage bus (e.g., of the charging station), such a switched battery pack typically comprises at least five contactors. The increased number of contactors as such may lead to an increased risk of failure of the battery pack, e.g., a broken contactor may cause a failure of the battery pack. Furthermore, a broken contactor may even cause a short-circuit of the battery pack, which may cause a fire or even explosion.

Thus, there is a need to provide a method and system to improve the safety of the battery pack.

### Summary

It is an object of the present disclosure, to provide a new control method and system of a battery pack, which eliminates or alleviates at least some of the disadvantages of the prior art.

The invention is defined by the appended independent claims. Embodiments are set forth in the appended dependent claims, and in the following description and drawings.

According to a first aspect, there is provided a control method of a battery pack, wherein the battery pack comprises: a first node and a second node, a first battery string and a second battery string, configured to be electrically connected in series or parallel for collectively charging or outputting power via the first and second nodes, a plurality of switching elements each comprising two terminals, comprising:
a first switching element, electrically connected between a first terminal of the first battery string and the first node,
a second switching element, electrically connected between a second terminal of the first battery string and the second node,
a third switching element, electrically connected between a first terminal of the second battery string and the first node,
a fourth switching element, electrically connected between a second terminal of the second battery string and the second node, and
a fifth switching element, electrically connected between the first terminal of the first battery string and the second terminal of the second battery string;
wherein when the second, third and fifth switching elements are closed, the first and second battery strings are configured to be electrically connected in series between the first and second nodes;
when the first, second, third and fourth switching elements are closed, the first and second battery strings are configured to be electrically connected in parallel between the first and second nodes.

The control method comprises:
controlling the plurality of switching elements to open;
providing a plurality of sensors and the plurality of sensors measuring a respective voltage value on each terminal of each of the plurality of switching elements;
determining a status of each of the plurality of switching elements being open or closed, based on the measured voltage values;
upon determination of the status of each of the plurality of switching elements being open, the method comprising:
   when the fifth switching element is controlled to close, preventing any of the first and fourth switching elements from being closed, until determining the status of each of the plurality of switching elements being open; and
   when any of the first and fourth switching elements is controlled to close, preventing the fifth switching element from being closed, until determining the status of each of the plurality of switching elements being open.

When the status of each of the plurality of switching elements is open, it may imply that none of the plurality of switching elements is stuck in its closed status. Since a switching element stuck in its closed status may cause safety problems of the battery pack, such as a short-circuit of the battery pack, this method may improve the safety of the battery pack.

After determining that none of the plurality of switching elements is stuck in its closed status, preventing the fifth switching element and any of the first and fourth switching elements from being closed simultaneously may also reduce a risk of the battery pack being short-circuited. This may improve the safety of the battery pack.

The term "battery string" may refer to one or more battery cells connected as a string to deliver power. The battery cells may be configured to be connected in series, in parallel, or a mixture of both. The battery string may be configured to deliver a desired voltage between its two terminals. For example, both the first battery string and the second battery string may be configured to deliver 400 V, as a desired voltage, between their respective two terminals.

The first and second battery strings may comprise the same or different numbers of battery cell(s). The same or different numbers of battery cell(s) may be connected in the same or different ways.

The first and second battery strings may be configured to deliver the same desired voltage.

The switching element may be an electrically controlled switch for disconnecting and connecting a conducting path. The switching element may be controlled by a control signal to close and open. The switching element may comprise two or more terminals for electrically connecting to a conducting path.

The status of a switching element may comprise open and closed.

The battery pack may comprise at least one sensor provided on each terminal of the plurality of switching elements. For example, the battery pack may comprise five switching elements and ten sensors, wherein each switching element is provided with two sensors for sensing a respective voltage value on each terminal of said switching element.

The sensor may be a voltage sensor for measuring the voltage value on one point of an electric circuit.

The sensor may comprise a transistor, e.g., a Metal Oxide Semiconductor Field Effect Transistor (MOSFET).

The method may comprise upon determination of the status of any of the plurality of switching elements being closed, outputting a result indicating a failure.

The method may comprise upon determination of the status of any of the plurality of switching elements being closed, disconnecting the battery pack from the first and second nodes. By disconnecting the battery pack from the first and second nodes, the battery pack may be disconnected from both the vehicle comprising the battery pack, and the charging station which is connected to the battery pack for charging.

The inventive concept is by checking whether all the switching elements are open, to identify if any of those switching elements is stuck in a closed status, such that a risk of short-circuit caused by the stuck closed switching elements can be reduced.

Furthermore, after confirming all the switching elements are open, by preventing certain combinations of switching elements from being closed simultaneously, the risk of short-circuit can be further reduced, as it is less possible that at least two switching elements are stuck in the closed status (e.g., got broken) simultaneously after successfully verifying that all the switching elements are open.

The step of determining a status of the plurality of switching elements being open or closed, may comprise determining the status of the fifth switching element, comprising:
measuring a first voltage on one terminal of the fifth switching element connected to the first battery string, by using the second terminal of the first battery string as a reference,
measuring a second voltage on another terminal of the fifth switching element connected to the second battery string, by using the second terminal of the first battery string as a reference,
upon determination of the first voltage being equal to a voltage across the first battery string, and the second voltage being not equal to the voltage across the first battery string, determining the status of the fifth switching element being open,
otherwise, determining the status of the fifth switching element being closed.

The method may comprise upon determination of the status of the fifth switching element being closed, outputting a result indicating a failure of the fifth switching element being stuck closed.

A voltage across a battery string may refer to a potential difference of two terminals of said battery string. For example, the voltage across the first battery string may be a voltage of its positive terminal, when its negative terminal is considered as the ground.

The method may comprise upon determination of the status of the fifth switching element being closed, disconnecting the battery pack from the first and second nodes.

The step of determining a status of the plurality of switching elements being open or closed, may comprise determining the status of the first switching element, comprising:
measuring a third voltage on one terminal of the first switching element connected to the first battery string, by using the second terminal of the first battery string as a reference,
measuring a fourth voltage on another terminal of the first switching element connected to the first node, by using the second terminal of the first battery string as a reference,
upon determination of the third voltage being equal to a voltage across the first battery string, and the fourth voltage being not equal to the voltage across the first battery string, determining the status of the first switching element being open,
otherwise, determining the status of the first switching element being closed.

The method may comprise upon determination of the status of the first switching element being closed, outputting a result indicating a failure of the first switching element being stuck closed.

The method may comprise upon determination of the status of the first switching element being closed, disconnecting the battery pack from the first and second nodes.

The step of determining a status of the plurality of switching elements being open or closed, may comprise determining the status of the second switching element, comprising:
measuring a third voltage on one terminal of the first switching element connected to the first battery string, by using the second terminal of the first battery string as a reference,
measuring a fifth voltage on said one terminal of the first switching element connected to the first battery string, by using the second node as a reference,
upon determination of the third voltage being equal to a voltage across the first battery string, and the fifth voltage being not equal to the voltage across the first battery string, determining the status of the second switching element being open,
otherwise, determining the status of the second switching element being closed.

The method may comprise upon determination of the status of the second switching element being closed, outputting a result indicating a failure of the second switching element being stuck closed.

The method may comprise upon determination of the status of the second switching element being closed, disconnecting the battery pack from the first and second nodes.

The step of determining a status of the plurality of switching elements being open or closed, may comprise determining the status of the third switching element, comprising:
measuring a sixth voltage on one terminal of the third switching element connected to the second battery string, by using the second terminal of the second battery string as a reference,
measuring a seventh voltage on another terminal of the third switching element connected to the first node, by using the second terminal of the second battery string as a reference,
upon determination of the sixth voltage being equal to a voltage across the second battery string, and the seventh voltage being not equal to the voltage across the second battery string, determining the status of the third switching element being open,
otherwise, determining the status of the third switching element being closed.

The method may comprise upon determination of the status of the third switching element being closed, outputting a result indicating a failure of the third switching element being stuck closed.

The voltage across the second battery string may be a voltage of its positive terminal, when its negative terminal is considered as the ground.

The method may comprise upon determination of the status of the third switching element being closed, disconnecting the battery pack from the first and second nodes.

The step of determining a status of the plurality of switching elements being open or closed, may comprise determining the status of the fourth switching element, comprising:
measuring a sixth voltage on one terminal of the third switching element connected to the second battery string, by using the second terminal of the second battery string as a reference,
measuring an eighth voltage on said one terminal of the third switching element connected to the second battery string, by using the second node as a reference,
upon determination of the sixth voltage being equal to a voltage across the second battery string, and the eighth voltage being not equal to the voltage across the second battery string, determining the status of the fourth switching element being open,
otherwise, determining the status of the fourth switching element being closed.

The method may comprise upon determination of the status of the fourth switching element being closed, outputting a result indicating a failure of the fourth switching element being stuck closed.

The method may comprise upon determination of the status of the fourth switching element being closed, disconnecting the battery pack from the first and second nodes.

The status of each of the plurality of switching elements may be determined in different orders. One example order is to determine the status of the fifth switching element, the first switching element, the second switching element, the third switching element, and the fourth switching element.

The battery pack may comprise a first pre-charge circuit, configured to be electrically connected in parallel to the first switching element; wherein the first pre-charge circuit may comprise a sixth switching element; when the status of each of the plurality of switching elements is open. The method may comprise:
when the fifth switching element is controlled to close, preventing any of the first, fourth and sixth switching elements from being closed, until determining the status of each of the plurality of switching elements being open;
when any of the first, fourth and sixth switching elements is controlled to close, preventing the fifth switching element from being closed, until determining the status of each of the plurality of switching elements being open.

A pre-charge circuit may be used to prevent stress and damage to a high voltage (e.g., above 100 V) electric system by limiting inrush current. The pre-charge circuit may comprise a resistor and a switching element connected in series.

The first pre-charge circuit may comprise a resistor connected in series with the sixth switching element.

The plurality of switching elements may comprise the sixth switching element.

The step of determining a status of the plurality of switching elements being open or closed, may comprise determining the status of the sixth switching element, comprising:
measuring a third voltage on one terminal of the first switching element connected to the first battery string, by using the second terminal of the first battery string as a reference,
measuring a fourth voltage on another terminal of the first switching element connected to the first node, by using the second terminal of the first battery string as a reference,
upon determination of the third voltage being equal to a voltage across the first battery string, and the fourth voltage being not equal to the voltage across the first battery string, determining the status of the sixth switching element being open,
otherwise, determining the status of the sixth switching element being closed.

The method may comprise upon determination of the status of the sixth switching element being closed, outputting a result indicating a failure of the sixth switching element being stuck closed.

The method may comprise upon determination of the status of the sixth switching element being closed, disconnecting the battery pack from the first and second nodes.

The status of both the first switching element and the sixth switching element can be determined by measuring the third and fourth voltages.

When the first pre-charge circuit comprises a resistor connected in series with the sixth switching element, and when there is a current through the first pre-charge circuit, the resistor will cause a voltage drop. The voltage drop may be taken into account when comparing the voltages for determining the status of the sixth switching element.

The voltage drop may be determined based on the current through the first pre-charge circuit and the resistance of the resistor.

The battery pack may comprise a second pre-charge circuit, configured to be electrically connected in parallel to the third switching element; wherein the second pre-charge circuit may comprise a seventh switching element; wherein the step of determining a status of the plurality of switching elements being open or closed, may comprise determining the status of the seventh switching element, comprising:
measuring a sixth voltage on one terminal of the third switching element connected to the second battery string, by using the second terminal of the second battery string as a reference,
measuring a seventh voltage on another terminal of the third switching element connected to the first node, by using the second terminal of the second battery string as a reference,
upon determination of the sixth voltage being equal to a voltage across the second battery string, and the seventh voltage being not equal to the voltage across the second battery string, determining the status of the seventh switching element being open,
otherwise, determining the status of the seventh switching element being closed.

The method may comprise upon determination of the status of the seventh switching element being closed, outputting a result indicating a failure of the seventh switching element being stuck closed.

The method may comprise upon determination of the status of the seventh switching element being closed, disconnecting the battery pack from the first and second nodes.

The status of both the third switching element and the seventh switching element may be determined by measuring the sixth and seventh voltages.

The plurality of switching elements may comprise the seventh switching element.

The method may comprise upon determination of the status of each of the plurality of switching elements being open, initiating a process of the battery pack which causes a change of voltage between the first and second nodes.

One goal is to confirm that none of the switching element is stuck in a closed status, prior to any process of the battery pack which may cause a voltage changes between the first and second nodes, e.g., a charging or a discharging process of the battery pack.

The method may comprise checking whether the plurality of sensors is functional, prior to the step of determining a status of the plurality of switching elements being open or closed.

If the plurality of sensors is functional, the measured voltages made by the plurality of sensors are reliable. Thus, the status of the switching elements can be determined based on the measured voltages.

However, since a broken sensor may provide an incorrect measured result, e.g., a zero Volt, which may lead to an incorrect determination of the status of one or more switching elements, checking whether the plurality of sensors is functional may further improve the safety of the battery pack.

The method may comprise upon determination of any of the sensor is malfunctional, outputting a result indicating a failure of the sensor.

The method may comprise upon determination of any of the sensor is malfunctional, disconnecting the battery pack from the first and second nodes.

The step of checking whether the plurality of sensors is functional may comprise: when determining the status of the fifth switching element,
controlling the fifth switching element to close,
measuring the first voltage and the second voltage,
upon determination of both the first voltage and the second voltage being equal to the voltage across the first battery string, determining sensors for measuring the first and second voltages being functional, and controlling the fifth switching element to open.

When determining the status of the first switching element, the method may comprise:
controlling the first switching element to close,
measuring the third voltage and the fourth voltage,
upon determination of both the third voltage and the fourth voltage being equal to the voltage across the first battery string, determining sensors for measuring the third and fourth voltages being functional, and controlling the first switching element to open.

When determining the status of the second switching element, the method may comprise:
controlling the second switching element to close,
measuring the third voltage and the fifth voltage,
upon determination of both the third voltage and the fifth voltage being equal to the voltage across the first battery string, determining sensors for measuring the third and fifth voltages being functional, and controlling the second switching element to open.

When determining the status of the third switching element, the method may comprise:
controlling the third switching element to close,
measuring the sixth voltage and the seventh voltage,
upon determination of both the sixth voltage and the seventh voltage being equal to the voltage across the second battery string, determining sensors for measuring the sixth and seventh voltages being functional, and controlling the third switching element to open.

When determining the status of the fourth switching element, the method may comprise:
controlling the fourth switching element to close,
measuring the sixth voltage and the eighth voltage,
upon determination of both the sixth voltage and the eighth voltage being equal to the voltage across the second battery string, determining sensors for measuring the sixth and eighth voltages being functional, and controlling the fourth switching element to open.

When determining the status of the sixth switching element, the method may comprise:
controlling the sixth switching element to close,
measuring the third voltage and the fourth voltage
upon determination of both the third voltage and the fourth voltage being equal to the voltage across the first battery string, determining sensors for measuring the third and fourth voltages (being functional, and controlling the sixth switching element to open.

When determining the status of the seventh switching element, the method may comprise:
controlling the seventh switching element to close,
measuring the sixth voltage and the seventh voltage,
upon determination of both the sixth voltage and the seventh voltage being equal to the voltage across the second battery string, determining sensors for measuring the sixth and seventh voltages being functional, and controlling the seventh switching element to open.

The same sensors may be used for measuring voltages on both terminals of the first switching element and of the sixth switching element.

The same sensors may be used for measuring voltages on both terminals of the third switching element and of the seventh switching element.

The control method of the battery pack, wherein any of the switching elements may be a contactor or a relay.

Both a contactor and a relay may be electrically operated switching elements. The contactor may be suitable to be connected to high voltage (e.g., hundreds of volts) load devices. And the relay may be suitable to be connected to low voltage load devices.

According to a second aspect, there is provided a battery pack control system of a battery pack, wherein the battery pack comprises:
a first node and a second node,
a first battery string and a second battery string, configured to be electrically connected in series or parallel for collectively charging or outputting power via the first and second nodes,
a plurality of switching elements each comprising two terminals, comprising:
   a first switching element, electrically connected between a first terminal of the first battery string and the first node,
   a second switching element, electrically connected between a second terminal of the first battery string and the second node,
   a third switching element, electrically connected between a first terminal of the second battery string and the first node,
   a fourth switching element, electrically connected between a second terminal of the second battery string and the second node, and
   a fifth switching element, electrically connected between the first terminal of the first battery string and the second terminal of the second battery string;
wherein when the second, third and fifth switching elements are closed, the first and second battery strings are configured to be electrically connected in series between the first and second nodes;
when the first, second, third and fourth switching elements are closed, the first and second battery strings are configured to be electrically connected in parallel between the first and second nodes;
wherein the battery pack control system comprises a control unit and a plurality of sensors;
wherein the control unit is configured to control the plurality of switching elements to open;
wherein the plurality of sensors is configured to measure a respective voltage value on each terminal of each of the plurality of switching elements.

The control unit is configured to:
determine a status of each of the plurality of switching elements being open or closed, based on the measured voltage values;
wherein, upon determination of the status of each of the plurality of switching elements being open, the control unit is configured to:
   when the fifth switching element is controlled to close, prevent any of the first and fourth switching elements from being closed, until determining the status of each of the plurality of switching elements being open; and
   when any of the first and fourth switching elements is controlled to close, prevent the fifth switching element from being closed, until determining of the status of each of the plurality of switching elements being open.

According to a third aspect, there is provided an electric vehicle or a hybrid electric vehicle comprising the battery pack control system according to the second aspect of the present disclosure.

### Brief Description of the Drawings

Fig. 1 is an example schematic circuit diagram of a battery pack.
Fig. 2a- fig. 2b are examples schematic circuit diagrams of the battery pack of fig. 1.
Fig. 3 is an example schematic circuit diagram of the battery pack of fig. 1.
Fig. 4 is an example schematic circuit diagram of a battery pack.
Fig. 5 is an example schematic circuit diagram of a battery pack.
Fig. 6 is an example of a diagram of a control method of a battery pack.

### Description of Embodiments

The present invention will now be described more fully hereinafter with reference to the accompanying drawings, in which currently preferred embodiments of the invention are shown.

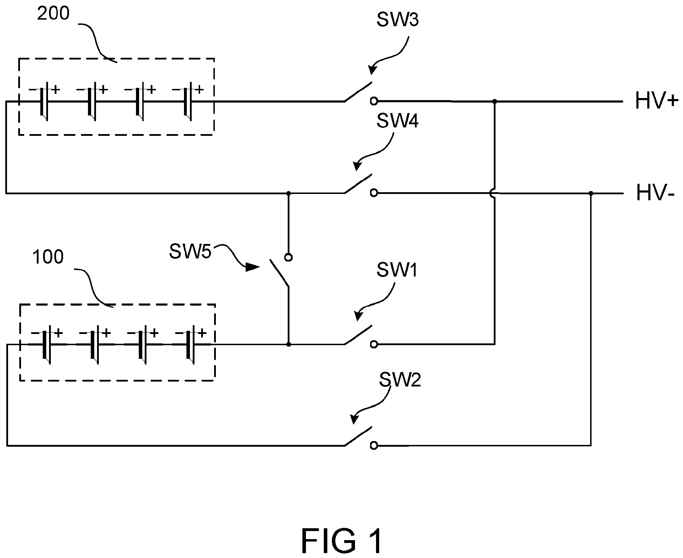

Fig. 1 is an example schematic circuit diagram of a battery pack. The battery pack may be a battery pack of an EV or HEV. The battery pack may be a rechargeable battery pack, e.g., for powering the electric motors of the EV or HEV. The battery pack may be used to power an electronic device of the EV or HEV.

The battery pack may comprise lithium-ion batteries, e.g., lithium-iron-phosphate (LFP) battery, lithium sulphur (Li-S) battery. The battery pack may comprise any suitable type of battery used for the EV or HEV, e.g., nickel manganese cobalt (NMC) battery, nickel metal hydride (Ni-MH) battery and lead-acid battery.

In the example of fig. 1, the battery pack comprises a first node HV+ and a second node HV-. Both the first node HV+ and the second node HV-are high voltage DC terminals. For example, the voltage across the first and second nodes may be 400 V or 800 V. The first and second nodes HV+, HV-may be used for collectively charging the battery pack or outputting power from the battery pack. The term "collectively" may be understood as that the first and second nodes HV+, HV- may be used as a positive node and a negative node, respectively, as a pair of nodes, for charging the battery pack or outputting power from the battery pack.

For example, the first and second nodes HV+, HV- may be used for connecting to an external power supply (e.g., a charging station) directly or indirectly, for charging the battery pack. For example, the first and second nodes HV+, HV- may be used as two power supply nodes, for outputting the power of the battery pack to another entity, e.g., an electric motor.

The battery pack comprises a first battery string 100 and a second battery string 200. The term "battery string" may refer to one or more battery cells being connected as a string.

The battery cell may be any type of cylindrical cell, prismatic cell, coin cell, pouch cells, solid state battery cell and liquid air battery cell. The battery cells may be configured to be connected in series, in parallel, or a mixture of both.

The battery string may be configured to deliver a desired voltage between its two terminals. The first and second battery strings 100, 200 may be configured to deliver the same desired voltage. For example, both the first battery string 100 and the second battery string 200 may be configured to deliver 400 V, as a desired voltage, between their respective two terminals. The actual voltage presented across the battery string may be different than the desired voltage. The desired voltage may be the voltage when the battery string is fully charged.

The first and second battery strings 100, 200 may comprise the same or different numbers of battery cell(s). The same or different numbers of battery cell(s) may be connected in the same or different ways.

The first and second battery strings 100, 200 may be electrically connected in series or parallel for collectively charging the battery pack or outputting power from the battery pack via the first and second nodes HV+, HV-.

The battery pack comprises a plurality of switching elements, comprising: a first switching element SW1, a second switching element SW2, a third switching element SW3, a fourth switching element SW4, and a fifth switching element SW5.

The switching element may be an electrically controlled switch for disconnecting and connecting a conducting path. The switching element may be controlled by a control signal to close and open. The switching element may comprise two or more terminals for electrically connecting to a conducting path.

The switching element may be a contactor or a relay. Both a contactor and a relay may be electrically operated switching elements. The contactor may be suitable to be connected to high voltage (e.g., hundreds of volts) load devices. And the relay may be suitable to be connected to low voltage load devices.

The status of a switching element may comprise open and closed. When a switching element is broken, it may stick in a closed status, such that even if it is controlled to open, it remains closed. This may cause a failure of the battery pack.

The first switching element SW1 is electrically connected between a first terminal (e.g., a positive terminal) of the first battery string 100 and the first node HV+ by its two terminals.

By electrically connecting the switching element SW1 between the first terminal of the first battery string 100 and the first node HV+, the first switching element SW1 may function as a switch for disconnecting and connecting a conducting path between the first terminal of the first battery string 100 and the first node HV+, with its open and closed status, respectively.

For example, when the switching element SW1 is closed (i.e., its status is closed), the first terminal of the first battery string 100 is connected to the first node HV+. Consequently, electric potentials of the two terminals of the closed switching element SW1 may be substantially the same.

For example, when the switching element SW1 is open (i.e., its status is open), the conducting path between the first terminal of the first battery string 100 and the first node HV+ is disconnected. Consequently, the electric potential of one terminal of the switching element SW1 connected to the first terminal of the first battery string 100, and the electric potential of another terminal of the switching element SW1 connected to the first node HV may be different.

Accordingly, the voltage of each terminal of the switching element SW1 may be used for determining its status being open or closed. The electric potential may be measured by a sensor, e.g., a voltage sensor.

The electric potential of a point may be a potential difference by comparing with a reference. The electric potential of the reference may be zero. Typically, the reference may be earth or ground of an electric circuit, although any point can be used as the reference. The electric potential of a point may be expressed as a voltage with a unit volt. Thus, the voltage of the same point may be different when measured with different references.

Analogously, the above examples of the first switching element SW1 are also applicable to all the switching elements provided in the present application. That is, each switching element may function as a switch for disconnecting and connecting a conducting path that said switching element is connected to. The status of each switching element may be determined based on the voltage of each terminal of said switching element.

The second switching element SW2 is electrically connected between a second terminal (e.g., a negative terminal) of the first battery string 100 and the second node HV- by its two terminals. The second switching element SW2 may function as a switch for disconnecting and connecting a conducting path between the second terminal of the first battery string 100 and the second node HV-, with its open and closed status, respectively.

The third switching element SW3 is electrically connected between a first terminal (e.g., a positive terminal) of the second battery string 200 and the first node HV+ by its two terminals. The third switching element SW3 may function as a switch for disconnecting and connecting a conducting path between the first terminal of the second battery string 200 and the first node HV+, with its open and closed status, respectively.

The fourth switching element SW4 is electrically connected between a second terminal (e.g., a negative terminal) of the second battery string 200 and the second node HV- by its two terminals. The fourth switching element SW4 may function as a switch for disconnecting and connecting a conducting path between the second terminal of the second battery string 200 and the second node HV-, with its open and closed status, respectively.

The fifth switching element SW5 is electrically connected between the first terminal (e.g., a positive terminal) of the first battery string 100 and the second terminal (e.g., a negative terminal) of the second battery string 200 by its two terminals. The fifth switching element SW5 may function as a switch for disconnecting and connecting a conducting path between the first terminal of the first battery string 100 and the second terminal of the second battery string 200, with its open and closed status, respectively.

The battery pack may comprise additional switching element(s).

By controlling to open or close any one of the switching elements, the respective conducting path may be disconnected or connected. For example, by closing different sets of switching elements, the two battery strings 100, 200 may be connected in parallel or in series. Thus, this may allow the battery pack to switch between different charging voltages.

When the second, third and fifth switching elements SW2, SW3, SW5 are closed, the first and second battery strings 100, 200 are electrically connected in series between the first and second nodes HV+, HV-.

When the first, second, third and fourth switching elements SW1, SW2, SW3, SW4 are closed, the first and second battery strings 100, 200 are electrically connected in parallel between the first and second nodes HV+, HV-.

The method provided herein is advantageous for improving the safety of the battery pack at least during the switching between the two battery strings 100, 200 being connected in parallel and in series.

The battery pack control system of the battery pack may be a system controlling and managing the battery pack. The battery pack control system may be a separate unit or an integral part of the battery pack.

The battery pack control system comprises a plurality of sensors (not shown). The plurality of sensors is configured to measure a respective voltage on each terminal of each of the plurality of switching elements.

Alternatively, the battery pack may comprise the plurality of sensors.

At least one sensor may be provided on each terminal of each of the plurality of switching elements. For example, the battery pack control system of the battery pack in fig. 1 may comprise ten sensors, wherein each of the five switching elements is provided with two sensors for sensing a respective voltage on each terminal of said switching element.

The sensor may be a voltage sensor of any suitable type for measuring the voltage on one point of an electric circuit. The plurality of sensors may be the same type or different types.

The sensor may comprise a transistor, e.g., a Metal Oxide Semiconductor Field Effect Transistor (MOSFET). The battery pack control system comprises a control unit.

The control unit is configured to control the plurality of switching elements to open, and to determine a status of each of the plurality of switching elements being open or closed, based on the measured voltages.

Upon determination of the status of each of the plurality of switching elements being open, the control unit is configured to:
when the fifth switching element SW5 is controlled to close, prevent any of the first and fourth switching elements SW1, SW4 from being closed, until determination of the status of each of the plurality of switching elements being open; and
when any of the first and fourth switching elements SW1, SW4 is controlled to close, prevent the fifth switching element SW5 from being closed, until determination of the status of each of the plurality of switching elements being open.

The control unit may comprise a processing circuit, such as a central processing unit (CPU), microcontroller, or microprocessor and/or any other electronic function unit which may perform the function.

The control unit may comprise a memory. The processing circuit may be configured to execute program codes stored in the memory, in order to carry out functions and operations of the control unit.

The memory may be one or more of a buffer, a flash memory, a hard drive, a removable medium, a volatile memory, a non-volatile memory, a random-access memory (RAM), or another suitable device. In a typical arrangement, the memory may include a non-volatile memory for long term data storage and a volatile memory that functions as a system memory for the control unit. The memory may exchange data with the processing circuit over a data bus. Accompanying control lines and an address bus between the memory and the processing circuit also may be present.

Functions and operations of the control unit may be embodied in the form of executable logic routines (e.g., lines of code, software programs, etc.) that are stored on a non-transitory computer readable medium (e.g., the memory) of the control unit and are executed by the processing circuit.

Furthermore, the functions and operations of the control unit may be a stand-alone software application or form a part of a software application that carries out additional tasks related to the control unit. The described functions and operations may be considered a method that the corresponding device is configured to carry out. Also, while the described functions and operations may be implemented in software, such functionality may as well be carried out via dedicated hardware or firmware, or some combination of hardware, firmware and/or software.

The control unit may comprise a user interface. The user interface may be configured to output data and to receive data from one or several input devices.

The input device may be a computer mouse, a keyboard, a track ball, a touch screen, or any other input device. The user interface may send the received data to the processing circuit for further processing.

The output data may comprise information regarding the status of the switching element, a result indicating a failure of the switching element, etc. The user interface may include a display for displaying the output data.

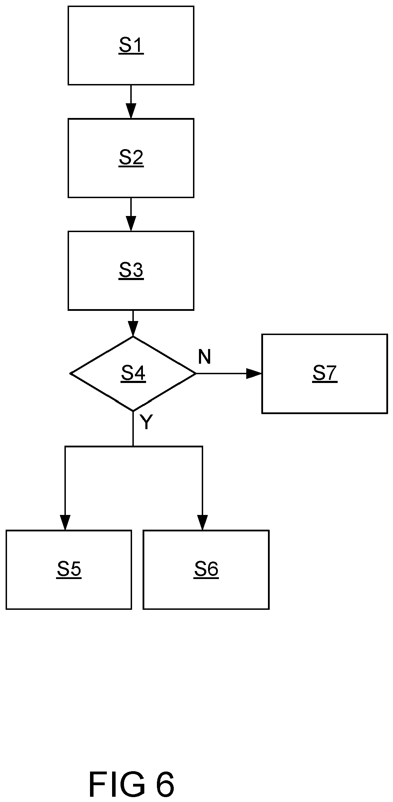

In connection with fig. 6, the control method of a battery pack will be discussed in more detail.

Fig. 6 is an example of a diagram of a control method of a battery pack.

The method comprises controlling the plurality of switching elements, SW1, SW2 ... to open (S1). The plurality of switching elements may be controlled to open simultaneously or individually and/or in a grouped order.

By controlling to open the plurality of switching elements, and then checking the status of each of the plurality of switching elements, it is possible to determine whether any switching element is stuck closed. This may increase the safety of controlling of the battery pack.

The method also comprises providing a plurality of sensors and the plurality of sensors measuring a respective voltage on each terminal of each of the plurality of switching elements (S2) and determining a status of each of the plurality of switching elements being open or closed, based on the measured voltages (S3).

The method may, for each switching element, determine whether it is open or closed, by measuring and comparing the voltage of each terminal of said switching element. If the two voltages are equal, it may be determined that said switching element is closed. If the two voltages are not equal, it may be determined that said switching element is open.

Two voltages may be determined to be equal, when an absolute difference between the two voltages is zero, or equal to or less than a threshold. Two voltages may be determined not to be equal, when an absolute difference between the two voltages is not zero, or larger than the threshold.

The threshold may be 50 V, preferably 20 V, most preferably 5 V.

For example, when an absolute difference between the two voltages measured at the terminals of one switching element is at least 100 V, which is larger than the threshold (e.g., 50 V), the two voltages may be determined not to be equal. Thus, the status of the switching element may be determined to be open. For example, when an absolute difference of the two voltages is less than the threshold (e.g., 50 V), the two voltages may be determined to be equal. The status of the switching element may be determined to be closed.

Alternatively, or in combination, the threshold may be 50 %, preferably 20 %, most preferably 5%, of any one of the two voltages.

For example, when one voltage is 100 V, another voltage is 0 V, and a difference between the two voltages is 100 V which is larger than the 50 % of any of the two voltages. The two voltages may be determined not to be equal. Thus, the status of the switching element may be determined to be open.

For example, when one voltage is 400 V, another voltage is 300 V, and a difference between the two voltages is 100 V which is small than the 50 % of any of the two voltages. The two voltages may be determined to be equal. Thus, the status of the switching element may be determined to be closed.

The threshold may be predetermined to allow a noise margin. Setting different thresholds for different battery packs may improve flexibility of the method and system.

The method comprises determining whether a status of each of the plurality of switching elements being open (S4). This method may determine whether all the switching elements are open, or if any of those switching elements is stuck in a closed status, so that a risk of short-circuit caused by the stuck closed switching elements may be reduced. The method provided herein may increase the safety of the battery pack and identify a failure of a switching element.

The method may be performed before and/or after charging of the battery pack. The method may be performed before and/or after the switching between the two battery strings 100, 200 being connected in parallel and in series.

Upon determination of the status of at least one switching element being closed (S4-N), the method may comprise indicating a failure (S7), by any suitable means, such as by an output signal, e.g., by a light indication, by displaying an error message, by playing an alarm, etc.

Alternatively, or in combination, upon determination of the status of at least one switching element being closed (S4-N), the method may comprise disconnecting the battery pack from the first and second nodes. The control unit may disconnect the battery pack, e.g., from a charging outlet of a charging station, or an electronic device it powers.

In connection to fig. 1, if the second switching element SW2, the fourth switching element SW4 and the fifth switching element SW5 are closed (i.e., having a closed status) at the same time, the first battery string 100 will be short-circuited because both its first and second terminals are connected to the second node HV-. Correspondingly, if the third switching element SW3, the first switching element SW1 and the fifth switching element SW5 are closed (i.e., having a closed status) at the same time, the second battery string 200 will be short-circuited because both its first and second terminals are connected to the first node HV+.

Accidentally connecting the first and second terminals of a battery string will cause excessive discharging of the battery string and cause serious damaging to the battery string, such as over current, overheat, burning and even exploding. Therefore, by checking whether any switching element is stuck in its closed status, the risk of short-circuit can be reduced, and the safety of the battery pack may be improved.

Upon determination of the status of each of the plurality of switching elements being open (S4-Y), the method further comprises: when the fifth switching element SW5 is controlled to close, preventing any of the first and fourth switching elements SW1, SW4 from being closed, until determination of the status of each of the plurality of switching elements being open in step S4 again (S5), and when any of the first and fourth switching elements SW1, SW4 is controlled to close, preventing the fifth switching element SW5 from being closed, until determination of the status of each of the plurality of switching elements being open in step S4 again (S6).

By checking the status of the switching elements, the method may identify if any of these switching elements is stuck in a closed status, such that a risk of short-circuit caused by the stuck closed switching elements can be reduced.

After it is confirmed that all the switching elements are open (S4-Y), by preventing the switching element SW5 being closed if any of the switching elements SW1 and SW4 is closed and preventing any of the switching elements SW1 and SW4 being closed when the switching element SW5 is closed, the risk of short-circuit of both the first battery string 100 and the second battery string 200 are further reduced.

Preventing the fifth switching element SW5 from being closed when the fourth switching element SW4 is closed may reduce the risk of the first battery string 100 being short-circuited. Preventing the fifth switching element SW5 from being closed when the first switching element SW1 is closed may reduce the risk of the second battery string 200 being short-circuited. Vice versa, by preventing the any of the switching elements SW1, SW4 from being closed when the switching element SW5 is closed, may also reduce the risk of the battery strings 100, 200 from being short-circuited.

Thus, preventing certain combination of switching elements from being closed at the same time, may advantageously improve the safety of the battery pack.

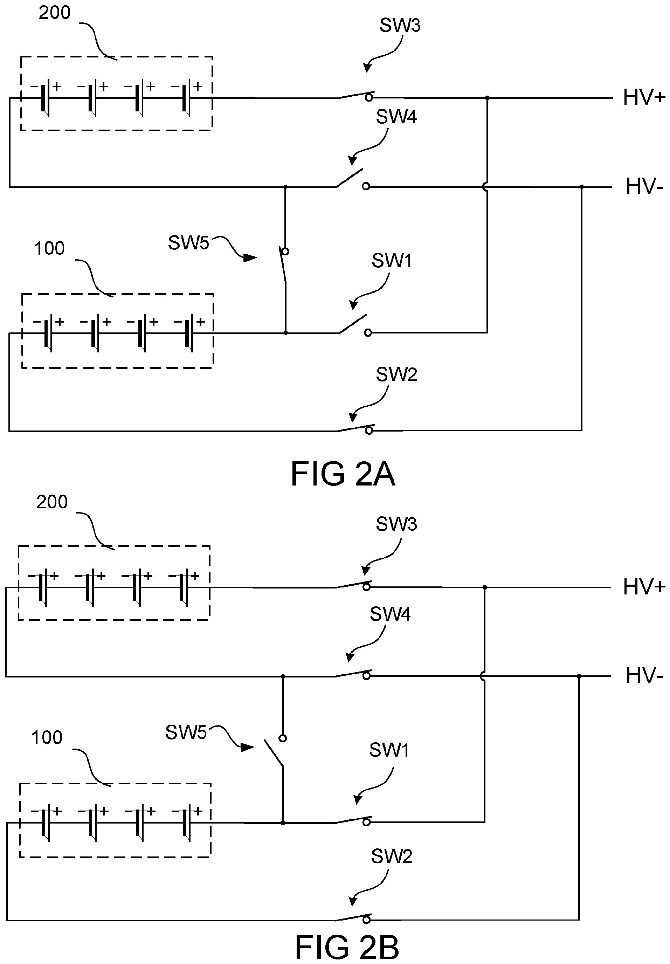

In connection with fig. 2a- fig. 2b, the functions of the switching elements will be discussed in more detail.

Figs 2a- 2b are two examples of the schematic circuit diagram of the battery pack of fig. 1.

In fig. 2a, when the second, third and fifth switching elements SW2, SW3, SW5 are closed, the battery strings 100, 200 are electrically connected in series between the first and second nodes HV+, HV-. The voltage between the first node HV+ and the second node HV- may be equal to a sum of the voltages of the battery strings 100 and 200. For example, each of the battery strings 100, 200 may have the same voltage value of 400 V, when they are connected in series, the voltage between the first node HV+ and the second node HV- may be 800 V. Each battery string may have the same voltage, e.g., in a range of 100 V to 1000 V, preferably in a range of 400 V to 800 V.

When the first and second battery strings 100, 200 are connected in series, the battery pack may allow the first and second battery strings being charged through the first and second nodes HV+, HV- with a voltage being larger than the voltage across either of the battery string 100 or 200. For example, when the capacity of each of the first and second battery strings is 400 V (i.e., the voltage across either the battery strings 100 and 200 is 400 V when they are fully charged) and they are connected in series, they may be charged by the charging station charging with 800 V DC through the first and second nodes HV+, HV-. Charging with a higher voltage may provide a higher power efficiency.

In fig. 2b, when the first, second, third and fourth switching elements SW1, SW2, SW3, SW4 are closed, the first and second battery strings 100, 200 are configured to be electrically connected in parallel between the first and second nodes HV+, HV-. The voltage between the first node HV+ and the second node HV- may be equal to the voltage across the battery string 100 or the voltage across the battery string 200.

When the first and second battery strings 100, 200 of the battery pack are connected in parallel, the battery pack may allow the first and second battery string 100 and 200 being charged through the first and second nodes HV+, HV- with the same voltage across each of the first and second battery string 100, 200. For example, when the capacity of each of the battery strings 100 and 200 is 400 V (i.e., the voltage across either the battery strings 100 and 200 is 400 V when they are fully charged) and they are connected in parallel, they may be charged by the charging station charging with 400 V DC through the first and second nodes HV+, HV-. Each battery string may have the same voltage, e.g., in a range of 100 V to 1000 V, preferably in a range of 400 V to 800 V.

The battery pack may comprise more than two battery strings, such as three battery strings, four battery strings, etc., connected between the first and second nodes HV+, HV-. These battery strings may be connected in series or in parallel between the first and second nodes HV+, HV-. These battery strings may have the same or different configurations as the first or second battery strings 100, 200. The battery strings may comprise different types and/or numbers of battery cells.

When there are more than two battery strings, the examples of fig. 2a-fig. 2b provided above are applicable. Consequently, the battery pack may comprise additional switching elements for connecting the additional battery strings between the first and second nodes HV+, HV-.

It is advantageously provided a safety control method, that the battery pack may be charged using different charging voltages between the first and second nodes HV+, HV-, by switching the battery strings of the battery pack between the two battery strings 100, 200 being connected in series and in parallel.

For example, the control method may be performed before switching the two battery strings 100, 200 from being connected in series to being connected in parallel, and vice versa. The method may improve the safety of the battery pack by checking whether the status of each of the plurality of the switching elements is open before the switching, since the method may identify any switching element being stuck closed and reduce the risk of serious safety accident caused by short-circuiting the battery strings.

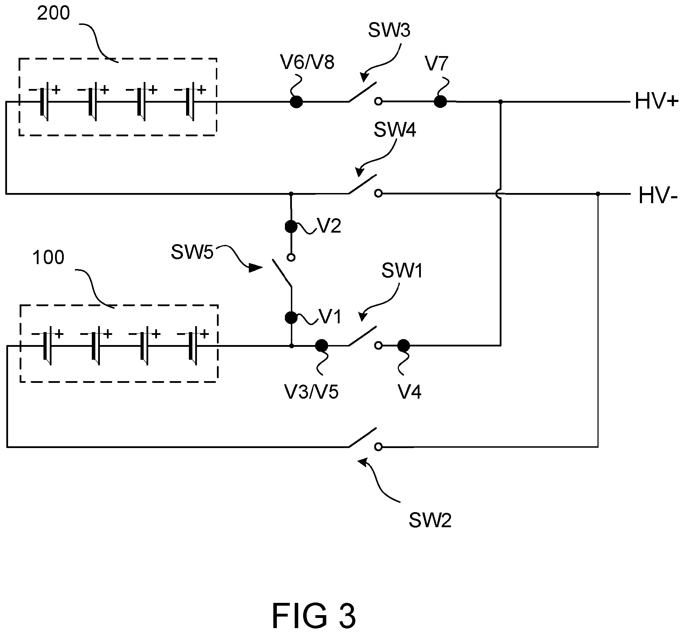

In connection with fig. 3, the step of determining a status of each of the plurality of switching elements being open or closed, based on the measured voltages, will be discussed in more detail.

The step of determining a status of the plurality of switching elements being open or closed may comprise determining the status of the fifth switching element SW5.

The method may comprise measuring a first voltage V1 on one terminal of the fifth switching element SW5 connected to the first battery string 100, by using the second terminal of the first battery string 100 as a reference.

"One terminal" of a switching element may refer to a first terminal of the switching element, "another terminal" of the switching element may refer to a second terminal of the switching element. The switching element may be connected to the conducting path via its two terminals. A switching element, e.g., SW1, SW2, SW3... may comprise more than two terminals. For example, the switching element may be controlled to change its open and closed status between the first and second terminals by means of electricity or magnetic force. The open and/or closed status provided between the first and second terminals then represents the open or closed status of the switching element.

The first voltage V1 is an electric potential measured at the first terminal of the fifth switching element SW5 connected with the first terminal of the first battery string 100, using an electric potential of the second terminal of the first battery string 100 as a reference. That is, the first voltage V1 is an electric potential difference between the electric potential at the first terminal of the fifth switching element SW5 and the electric potential of the second terminal of the first battery string 100.

The first voltage V1 may be measured by the sensor provided for measuring a voltage of the first terminal of the fifth switching element SW5. The voltage sensor may be directly connected to the first terminal of the fifth switching element SW5.

Furthermore, the method may comprise measuring a second voltage V2 on another terminal of the fifth switching element SW5 connected to the second battery string 200, by using the second terminal of the first battery string 100 as a reference.

The second voltage V2 is an electric potential measured at the second terminal of the fifth switching element SW5 connected with the second terminal of the second battery string 200, using the electric potential of the second terminal of the first battery string 100 as a reference. That is, the second voltage V2 is an electric potential difference between the electric potential at the second terminal of the fifth switching element SW5 and the electric potential of the second terminal of the first battery string 100.

The voltages V1, V2, V3... are preferably measured on a point having the same electric potential of the terminals of the switching elements, which means there may be no other electronic component provided between the measuring point of the sensor and the terminal of any switching element.

The method may comprise upon determination of the first voltage V1 being equal to a voltage across the first battery string 100, and the second voltage V2 being not equal to the voltage across the first battery string 100, determining the status of the fifth switching element SW5 being open, otherwise, determining the status of the fifth switching element SW5 being closed.

When the fifth switching element SW5 is open, the electric potentials of the two terminals of the fifth switching element SW5 may be different, since the conducting path between the measuring points of the first voltage V1 and second voltage V2 are disconnected by the fifth switching element SW5, so the electric potentials may be different and the first voltage V1 measured on the one terminal of the fifth switching element SW5 being connected to the first terminal of the first battery string 100 may be equal to the voltage across the first battery string 100. Thus, it may determine the open status of the switching element SW5, when the first and second voltages V1, V2 are different and the first voltage V1 is equal to the voltage across the first battery string 100. When the fifth switching element SW5 is closed, the two terminals of the fifth switching element SW5 are electrically connected, and the measuring points of the first and second voltage V1, V2 may have substantially the same electric potential using the same reference potential (as the internal resistance of a switching element is very small). Thus, it may determine the fifth switching element SW5 being closed, when the first and second voltages V1, V2 are equal, e.g., equal to the voltage across the first battery string 100.

Such determinations may be based on that there is no other component in the same conducting path causing an open status, e.g., a melt fuse or a broken wire. If any other component of the conducting path is broken, the first voltage V1 and the second voltage V2 may both be equal to zero, which may lead to an error in determination. If any of the fourth switching element SW4 and the second switching element SW2 is also open, the second voltage V2 may be the potential of the open circuit which presents as zero. In this case, the first voltage V1 may be equal to the second voltage V2, and equal to zero. This result may be wrongly taken as the fifth switching element SW5 being closed while the fifth switching element SW5 is open. There may be other conditions such as, when a sensor is broken, the voltage result may be also wrongly presented.

The status/functionality of other component(s) of the battery pack, such as a fuse, and/or the sensors of the battery pack control system, may be checked in advance before the determination of a status of the fifth switching element SW5, which may further improve the reliability of the method.

The method of checking the status of other components may be relevant to all switching elements. It may be provided in advance to the determination of a status of any switching element.

The method may comprise upon determination of the status of the fifth switching element SW5 being closed, outputting a result indicating a failure of the fifth switching element SW5 being stuck closed. By outputting a failure of a switching element, the safety of the battery pack may be further improved.

The method may comprise upon determination of the status of the fifth switching element SW5 being closed, disconnecting the battery pack from the first and second nodes HV+, HV-. This may increase the safety of the battery pack and prevent any risks, e.g., short-circuit of the battery pack.

The step of determining a status of the plurality of switching elements being open or closed, may comprise determining the status of the first switching element SW1.

In the example of fig. 3, the status of the first switching element SW1 may be determined using a third voltage V3 and a fourth voltage V4.

Determining the status of the first switching element SW1 may comprise measuring a third voltage V3 on one terminal of the first switching element SW1 connected to the first battery string 100, by using the second terminal of the first battery string 100 as a reference.

The third voltage V3 may be an electric potential measured at a first terminal of the first switching element SW1 connected with the first terminal of the first battery string 100, using the electric potential of the second terminal of the first battery string 100 as a reference. That is, the third voltage V3 is an electric potential difference between the electric potential at the first terminal of the first switching element SW1 and the electric potential of the second terminal of the first battery string 100.

At the same measuring point, different voltages may be measured depending on the reference (the reference potential) the measurement uses. More than one sensor using different references may be connected to the same measure point, where voltages having different references may be measured. The control unit of the battery pack control system may process the voltages measured by the sensors simultaneously or individually.

For example, in fig. 3, the third voltage V3 and the fifth voltage V5 may be measured at the same measuring point with two different sensors using different references (different reference potentials).

The sensor(s) may be used for measuring voltages at a terminal of other components of the battery pack, e.g., a fuse, a converter, a pre-charge circuit, etc. The voltage of a terminal of the component may be measured by comparing the electric potential at the voltage measurement point with a reference potential. The control unit of the battery pack control system may process the voltages measured by any of the sensor simultaneously or individually.

The method may comprise measuring a fourth voltage V4 on another terminal of the first switching element SW1 connected to the first node HV+, by using the second terminal of the first battery string 100 as a reference.

The fourth voltage V4 may be an electric potential measured at the second terminal of the first switching element SW1 connected with the first node HV+, using the electric potential of the second terminal of the first battery string 100 as a reference. That is, the fourth voltage V4 is an electric potential difference between the electric potential at the second terminal of the first switching element SW1 and the electric potential of the second terminal of the first battery string 100.

Upon determination of the third voltage V3 being equal to a voltage across the first battery string 100, and the fourth voltage V4 being not equal to the voltage across the first battery string 100, determining the status of the first switching element SW1 being open, otherwise, determining the status of the first switching element SW1 being closed.

When the first switching element SW1 is open, the electric potentials of the two terminals of the first switching element SW1 may be different, since the conducting path between the measuring points of the third voltage V3 and fourth voltage V4 are disconnected by the first switching element SW1 being open. Thus, it may determine that the status of the switching element SW1 is open, when the third and fourth voltages V3, V4 are different and the third voltage V3 is equal to the voltage across the first battery string 100.

When the first switching element SW1 is closed, the conducting path between the measuring points of the third voltage V3 and fourth voltage V4 are connected via the first switching element SW1. The measuring points of the third and fourth voltage V3, V4 may have substantially the same electric potential (as the internal resistance of the first switching element SW1 is very small). Since both the third and fourth voltages V3, V4 are comparing to the same reference potential, e.g., the second terminal of the first battery string 100, it may determine the first switching element SW1 being closed, when the third and fourth voltages V3, V4 are equal to the voltage over the first battery string 100.

Such determinations of the first switching element SW1 may be based on that there is no other component(s) in the same conducting path causing an open status, e.g., a melt fuse or a broken wire, which may create an equal voltage for the third and the fourth voltages V3, V4 in the conducting path.

The status of other switching elements of the battery pack may influence the determination of the status of the first switching element SW1. For example, when the second, third and the fourth switching elements SW2, SW3 and SW4 are closed, and when the voltages across the first and the second battery strings 100, 200 are the same, the third and the fourth voltages V3, V4 may have the same voltage value even if the first switching element SW1 is open, since the third voltage V3 presenting the voltage across the first battery string 100 and the fourth voltage V4 presenting the voltage across the second battery string 200. The status of the first switching element SW1 being open may be wrongly determined to be closed.

The method may comprise determining whether any of the second, third and the fourth switching elements SW2, SW3 and SW4 being open in advance of determining the status of the first switching element SW1. The method may control and determine all switching elements being open before determining a switching element being closed.

The status/functionality of other component, such as a fuse and or a sensor, may be checked in advance before the determination of a status of the first switching element, which may further improve the reliability of the method.

The method may comprise upon determination of the status of the first switching element SW1 being closed, outputting a result indicating a failure of the first switching element SW1 being stuck closed.

The method may comprise upon determination of the status of the first switching element SW1 being closed, disconnecting the battery pack from the first and second nodes HV+. HV-. This may increase the safety of the battery pack and prevent any risks, e.g., short-circuit of the battery pack.

The step of determining a status of the plurality of switching elements being open or closed, may comprise determining the status of the second switching element SW2.

In the example of fig. 3, the status of the second switching element SW2 may be determined using the third voltage V3 and a fifth voltage V5.

Determining the status of the second switching element SW2 may comprise measuring the third voltage V3 on one terminal of the first switching element SW1 connected to the first battery string 100, by using the second terminal of the first battery string 100 as a reference.

The method may comprise measuring a fifth voltage V5 on said one terminal of the first switching element SW1 connected to the first battery string 100, by using the second node HV- as a reference.

The fifth voltage V5 may be an electric potential measured at the first terminal of the first switching element SW1 connected with the first terminal of the first battery string 100, using the electric potential of the second node HV-as a reference. That is, the fifth voltage V5 may be an electric potential difference between the electric potential at the first terminal of the first switching element SW1 and the electric potential of the second node HV-.

Upon determination of the third voltage V3 being equal to a voltage across the first battery string 100, and the fifth voltage V5 being not equal to the voltage across the first battery string 100, determining the status of the second switching element SW2 being open, otherwise, determining the status of the second switching element SW2 being closed.

The second switching element SW2 may be connected in the conducting path between the second terminal of the first battery string 100 (reference for the third voltage V3) and the second node HV- (reference for the fifth voltage V5). Since the third voltage V3 and fifth voltage V5 may both be measured from the first terminal of the first battery string 100, using the respective reference potential, the status of the second switching element SW2 being open or closed may be determined by the third voltage V3 and the fifth voltage V5.

When the second switching element SW2 is open, the second terminal of the first battery string 100 may be disconnected from the second node HV-. The potential of the second terminal of the first battery string 100 as the reference for the third voltage V3 may not be the same as the second node HV- as the reference for the fifth voltage V5. The third voltage V3 may not be the same as the fifth voltage V5. The third voltage V3 may present the voltage across the first battery sting 100. The fifth voltage V5 may be different from the voltage across the first battery sting 100. Thus, it may determine the status of the second switching element SW2 being open, when the third and fifth voltages V3, V5 are different and the third voltage V3 is equal to the voltage of the first battery string 100.

When the second switching element SW2 is closed, the second terminal of the first battery string 100 may be connected to the second node HV-. Consequently, the potential of the second terminal of the first battery string 100 as the reference for the third voltage V3 may be the same as the second node HV- as the reference for the fifth voltage V5. Therefore, when the second switching element SW2 is closed, the third voltage V3 may be the same as the fifth voltage V5 therein and may both be equal to the voltage across the first battery string 100. Thus, it may determine the status of the second switching element SW2 being closed, when the third and fifth voltages V3, V5 are equal to the voltage of the first battery string 100.

The status of other switching elements of the battery pack may influence the determination of the status of the second switching element SW2. For example, when the first, third and the fourth switching elements SW1, SW3 and SW4 are closed, and when the voltages across the first and the second battery strings 100, 200 are the same, the third and the fifth voltages V3, V5 may have the same voltage value even if the second switching element SW2 is open. For example, when the first switching element SW1 is closed, the fifth voltage V5 may be equal to the voltage across the second battery string 200, which may be equal to the third voltage V3 being equal to the voltage across the first battery string 100. The status of the second switching element SW2 being open may be wrongly determined to be closed.

The method may comprise determining whether any of the first, third and the fourth switching elements SW1, SW3 and SW4 being open in advance of determining the status of the second switching element SW2. The method may determine all switching elements being open before determining a switching element being closed.

The method may comprise upon determination of the status of the second switching element SW2 being closed, outputting a result indicating a failure of the second switching element SW2 being stuck closed. The method may comprise upon determination of the status of the second switching element SW2 being closed, disconnecting the battery pack from the first and second nodes HV+, HV-. This may increase the safety of the battery pack and prevent any risks, e.g., short-circuit of the battery pack.

The step of determining a status of the plurality of switching elements being open or closed, may comprise determining the status of the third switching element SW3.ln the example of fig. 3, the status of the third switching element SW3 may be determined using a sixth voltage V6 and a seventh voltage V7.

Determining the status of the third switching element SW3 may comprise measuring the sixth voltage V6 on one terminal of the third switching element SW3 connected to the second battery string 200, by using the second terminal of the second battery string 200 as a reference.

The sixth voltage V6 may be an electric potential measured at a first terminal of the third switching element SW3 connected with the first terminal of the second battery string 200, using the electric potential of the second terminal of the second battery string 200 as a reference. That is, the sixth voltage V6 is an electric potential difference between the electric potential at the first terminal of the third switching element SW3 and the electric potential of the second terminal of the second battery string 200.

The method may comprise measuring a seventh voltage V7 on another terminal of the third switching element SW3 connected to the first node HV+, by using the second terminal of the second battery string 200 as a reference.

The seventh voltage V7 may be an electric potential measured at the second terminal of the third switching element SW3 connected with the first node HV+, using the electric potential of the second terminal of the second battery string 200 as a reference. That is, the seventh voltage V7 may be an electric potential difference between the electric potential at the second terminal of the third switching element SW3 and the electric potential of the second terminal of the second battery string 200.

Upon determination of the sixth voltage V6 being equal to a voltage across the second battery string 200, and the seventh voltage V7 being not equal to the voltage across the second battery string 200, determining the status of the third switching element SW3 being open, otherwise, determining the status of the third switching element SW3 being closed.

When the third switching element SW3 is open, the electric potentials of its two terminals may be different, since the conducting path between the measuring points of the sixth voltage V6 and seventh voltage V7 are disconnected by the third switching element SW3 being open. The electric potentials may be different and the sixth voltage V6 may be equal to the voltage across the second battery string 200. Thus, it may determine the status of the switching element SW6 being open, when the sixth and seventh voltages V6, V7 are different and the sixth voltage V6 is equal to the voltage of the second battery string 200.

When the third switching element SW3 is closed, the measuring points of the sixth and seventh voltage V6, V7 may have substantially the same electric potential (as the internal resistance of the switching element SW3 is very small). Since both the sixth and seventh voltages V6, V7 are comparing to the same reference potential, e.g., the second terminal of the second battery string 200, it may determine the third switching element SW3 being closed, when the sixth and seventh voltages V6, V7 are equal to the voltage over the second battery string 200.

Such determination of the third switching element SW3 may be based on that there is no other component(s) in the same conducting path causing an open status, e.g., a melt fuse or a broken wire, which may create an equal voltage of the sixth and the seventh voltages V6, V7.

The status of other switching elements of the battery pack may influence the determination of the status of the third switching element SW3. For example, when the first, second and the fourth switching elements SW1, SW2 and SW4 are closed, and when the voltages across the first and the second battery strings 100, 200 are the same, the sixth and the seventh voltages V6, V7 may have the same voltage value even if the third switching element is open, since the sixth voltage V6 may represent the voltage across the second battery string 200 and the seventh voltage V7 may present the voltage across the first battery string 100. The status of the third switching element SW3 being open may be wrongly determined to be closed.

The method may comprise determining whether any of the first, second and the fourth switching elements SW1, SW2 and SW4 being open in advance of determining the status of the third switching element SW3. The method may control and determine all switching elements being open before determining a switching element being closed.

The method may comprise upon determination of the status of the third switching element SW3 being closed, outputting a result indicating a failure of the third switching element SW3 being stuck closed.

The method may comprise upon determination of the status of the third switching element SW3 being closed, disconnecting the battery pack from the first and second nodes HV+, HV-. This may increase the safety of the battery pack and prevent any risks, e.g., short-circuit of the battery pack.

The step of determining a status of the plurality of switching elements being open or closed may comprise determining the status of the fourth switching element SW4.

In the example of fig. 3, the status of the fourth switching element SW4 may be determined using the sixth voltage V6 and an eighth voltage V8.

Determining the status of the fourth switching element SW4 may comprise measuring the sixth voltage V6 on one terminal of the third switching element SW3 connected to the second battery string 200, by using the second terminal of the second battery string 200 as a reference.

The method may comprises measuring the eighth voltage V8 on said one terminal of the third switching element SW3 connected to the second battery string 200, by using the second node HV- as a reference.

The eighth voltage V8 may be an electric potential measured at the first terminal of the third switching element SW3 connected with the first terminal of the second battery string 200, using the electric potential of the second node HV- as a reference. That is, the eighth voltage V8 may be an electric potential difference between the electric potential at the first terminal of the third switching element SW3 and the electric potential of the second node HV-.
upon determination of the sixth voltage V6 being equal to a voltage across the second battery string 200, and the eighth voltage V8 being not equal to the voltage across the second battery string 200, determining the status of the fourth switching element SW4 being open, otherwise, determining the status of the fourth switching element SW4 being closed.

The fourth switching element SW4 may be connected in the conducting path between the second terminal of the second battery string 200 (reference for the sixth voltage V6) and the second node HV- (reference for the eighth voltage V8). Since the sixth voltage V6 and eighth voltage V8 may both be measured from the first terminal of the second battery string 200, using the respective reference potential, the status of the fourth switching element SW4 being open or closed may be determined by the sixth voltage V6 and the eighth voltage V8.

When the fourth switching element SW4 is open, the second terminal of the second battery string 200 may be disconnected from the second node HV-. The potential of the second terminal of the second battery string 200 as the reference for the sixth voltage V6 may not be the same as the second node HV- as the reference for the eighth voltage V8. The sixth voltage V6 may not be the same as the eight voltage V8. The sixth voltage V6 may present the voltage across the second battery sting 200. The eight voltage V8 may be different from the voltage across the second battery sting 200. Thus, it may determine the status of the fourth switching element SW4 being open, when the sixth and eighth voltages V6, V8 are different and the sixth voltage V6 is equal to the voltage of the second battery string 200.

When the fourth switching element SW4 is closed, the second terminal of the second battery string 200 may be connected to the second node HV-. Consequently, the potential of the second terminal of the second battery string 200 as the reference for the sixth voltage V6 may be the same as the second node HV- as the reference for the eighth voltage V8. Therefore, when the fourth switching element SW4 is closed, the sixth voltage V6 may be the same as the eighth voltage V8 therein and may both be equal to the voltage across the second battery string 200. Thus, it may determine the status of the fourth switching element SW4 being closed, when the sixth and eighth voltages V6, V8 are equal to the voltage of the second battery string 200.

The status of other switching elements of the battery pack may influence the determination of the status of the fourth switching element SW4. For example, when the first, second and third switching elements SW1, SW2 and SW3 are closed, and when the voltages across the first and the second battery strings 100, 200 are the same, the sixth and the eighth voltages V6, V8 may have the same voltage value even if the fourth switching element SW4 is open. For example, when the third switching element SW3 is closed, the eighth voltage V8 may be equal to the voltage across the first battery string 100, which may be equal to the sixth voltage V6 being equal to the voltage across of the second battery string 200. The status of the fourth switching element SW4 being open may be wrongly determined to be closed.

The method may comprise determining whether any of the first, second and third switching elements SW1, SW2 and SW3 being open in advance of determining the status of the fourth switching element SW4. The method may determine all switching elements being open before determining a switching element being closed.

The status of other component, such as a fuse and or a sensor may be checked in advance before the determination of a status of the fourth switching element SW4, which may further improve the reliability of the method.

The method may comprise upon determination of the status of the fourth switching element SW4 being closed, outputting a result indicating a failure of the fourth switching element SW4 being stuck closed.

The method may comprise upon determination of the status of the fourth switching element SW4 being closed, disconnecting the battery pack from the first and second nodes HV+, HV-. This may increase the safety of the battery pack and prevent any risks, e.g., short-circuit of the battery pack.

The status of each of the plurality of switching elements SW1, SW2, SW3... may be determined in different orders. One example order is to determine the status of the fifth switching element SW5 first, then the first switching element SW1, the second switching element SW2, the third switching element SW4, and finally the fourth switching element SW4.

The method may further comprise upon determination of the status of each of the plurality of switching elements being open, initiating a process of the battery pack which causes a change of voltage between the first and second nodes HV+, HV-.

One goal is to confirm that none of the switching element is stuck in a closed status, prior to any process of the battery pack which may cause a voltage changes between the first and second nodes, e.g., a charging or a discharging process of the battery pack.

The method may comprise checking whether the plurality of sensors is functional. This may be performed prior to the step of determining a status of the plurality of switching elements being open or closed.

If the plurality of sensors is functional, the voltages measured by the plurality of sensors are reliable. Thus, the status of the switching elements determined based on the measured voltages are reliable.

However, a malfunctional or broken sensor may provide an incorrect measured result, e.g., a zero Volt, which may lead to an incorrect determination of the status of one or more switching elements. Thus, checking whether the plurality of sensors is functional may further improve reliability of the control method, which may further improve the safety of the battery pack.

The safety control method provided herein is robust against sensor failures, e.g., a single sensor failure may be identified and may not lead to errors in the determination of status of the plurality of switching elements.

The method may comprise upon determination of any of the sensor is malfunctional, outputting a result indicating a failure of the sensor.

The method may comprise upon determination of any of the sensor is malfunctional, disconnecting the battery pack from the first and second nodes.

Checking whether the plurality of sensors is functional may comprise when determining a status of the fifth switching element SW5, controlling the fifth switching element SW5 to close.

When the fifth switching element SW5 is closed, the first voltage V1 and the second voltage V2 may have the same voltage value (as the internal resistance of the fifth switching element SW5 is very small) and having the same reference (the second terminal of the first battery string 100).

The method may comprise measuring the first voltage V1 and the second voltage V2, upon determination of both the first voltage V1 and the second voltage V2 being equal to the voltage across the first battery string 100, determining sensors for measuring the first and second voltages V1, V2 being functional.

By closing the fifth switching element SW5, the measuring points of both the first voltage V1 and the second voltage V2 are connected to the first terminal of the first battery string 100 and both the first voltage V1 and the second voltage V2 are measured with the reference potential of the second terminal of the first battery string 100, if the sensors for measuring the first and second voltages V1, V2 are functional, both the first voltage V1 and the second voltage V2 may be equal to the voltage across the first battery string 100. If any of the sensor for measuring the first voltage V1 or the second voltage V2 is broken, the first voltage V1 and the second voltage V2 may be different or may not be equal to voltage across the first battery string 100 voltage. The control unit may compare the first voltage V1 and the second voltage V2.

The method may comprise after determining the sensors for measuring the first voltage V1 and the second voltage V2 are functional, controlling the fifth switching element SW5 to open. Then, the step of determining the status of the fifth switching element SW5 may be performed.

The above of checking the sensors for measuring the first and second voltages V1, V2 are analogously applicable to other sensors, such as the sensors for measuring voltages of the terminals of other switching elements SW1, SW2, ....

Checking whether the plurality of sensors is functional may comprise when determining a status of the first switching element SW1, controlling the first switching element SW1 to close.

When the first switching element SW1 is closed, the third voltage V3 and the fourth voltage V4 may have the same voltage value (as the internal resistance of the first switching element SW1 is very small) and having the same reference (the second terminal of the first battery string 100).

The method may comprise measuring the third voltage V3 and the fourth voltage V4, upon determination of both the third voltage V3 and the fourth voltage V4 being equal to the voltage across the first battery string 100, determining sensors for measuring the third voltage V3 and the fourth voltage V4 being functional.

By closing the first switching element SW1, the measuring points of both the third voltage V3 and the fourth voltage V4 are connected to the first terminal of the first battery string 100 and both the third voltage V3 and the fourth voltage V4 are measured with the reference potential of the second terminal of the first battery string 100, if the sensors for measuring the third and fourth voltages V3, V4 are functional, both the third voltage V3 and the fourth voltage V4 may be equal to the voltage across the first battery string 100. If any of the sensor for measuring the third voltage V3 or the fourth voltage V4 is broken, the third voltage V3 and the fourth voltage V4 may be different or may not be equal to voltage across the first battery string 100. The control unit may compare the third voltage V3 and the fourth voltage V4.

The method may comprise after determining the sensors for measuring the third voltage V3 and the fourth voltage V4 are functional, controlling the first switching element SW1 to open. Then, the step of determining the status of the first switching element SW1 may be performed.

Checking whether the plurality of sensors is functional may comprise when determining a status of the second switching element SW2, controlling the second switching element SW2 to close.

When the second switching element SW2 is closed, the references for measuring V3 and V5 are the same. Then, the third voltage V3 and the fifth voltage V5 may have the same voltage value, since they are measured at the same measuring points.

The method may comprise measuring the third voltage V3 and the fifth voltage V5, upon determination of both the third voltage V3 and the fifth voltage V5 being equal to the voltage across the first battery string 100, determining sensors for measuring the third voltage V3 and the fifth voltage V5 being functional.

By closing the second switching element SW2, the references of both the third voltage V3 and the fifth voltage V5 are the same by the second switching element SW2 (as the internal resistance of the second switching element SW2 is very small). Both the third voltage V3 and the fifth voltage V5 are connected to the first terminal of the first battery string 100, if the sensors for measuring the third and fifth voltages V3 and V5 are functional, both the the third voltage V3 and the fifth voltage V5 may be equal to the voltage across the first battery string 100. If any of the sensor for measuring the third voltage V3 and the fifth voltage V5 is broken, the third voltage V3 and the fifth voltage V5 may be different or may not equal to voltage across the first battery string 100. The control unit may compare the third voltage V3 and the fifth voltage V5.

The method may comprise after determining both sensors are functional, controlling the second switching element SW2 to open. Then, the step of determining the status of the second switching element SW2 may be performed.

Checking whether the plurality of sensors is functional may comprise when determining a status of the third switching element SW3, controlling the third switching element SW3 to close.

When the third switching element SW3 is closed, the sixth voltage V6 and the seventh voltage V7 may have the same voltage value (as the internal resistance of the third switching element SW3 is very small) and having the same reference (the second terminal of the second battery string 200).

The method may comprise measuring the sixth voltage V6 and the seventh voltage V7, upon determination of both the sixth voltage V6 and the seventh voltage V7 being equal to the voltage across the second battery string 200, determining sensors for measuring the sixth voltage V6 and the seventh voltage V7 being functional.

By closing the third switching element SW3, the measuring points of both the sixth voltage V6 and the seventh voltage V7 are connected to the first terminal of the second battery string 200 and both the sixth voltage V6 and the seventh voltage V7 are measured with the reference potential of the second terminal of the second battery string 200, if the sensors for measuring the sixth voltage V6 and the seventh voltage V7 are functional, both the sixth voltage V6 and the seventh voltage V7 may be equal to the voltage across the second battery string 200. If any of the sensor for measuring the sixth voltage V6 and the seventh voltage V7 is broken, the sixth voltage V6 and the seventh voltage V7 may be different or may not be equal to voltage across the second battery string 200. The control unit may compare the sixth voltage V6 and the seventh voltage V7.

The method may comprise after determining the sensors for measuring the sixth voltage V6 and the seventh voltage V7 are functional, controlling the third switching element SW3 to open. Then, the step of determining the status of the third switching element SW3 may be performed.

Checking whether the plurality of sensors is functional may comprise when determining a status of the fourth switching element SW4, controlling the fourth switching element SW4 to close.

When the fourth switching element SW4 is closed, the references for measuring the sixth voltage V6 and the eighth voltage V8 are the same. Then the sixth voltage V6 and the eighth voltage V8 may have the same voltage value, since they are measured at the same measuring points.

The method may comprise measuring the sixth voltage V6 and the eighth voltage V8, upon determination of both the sixth voltage V6 and the eighth voltage V8 being equal to the voltage across the second battery string 200, determining sensors for measuring the sixth voltage V6 and the eighth voltage V8 being functional.

By closing the fourth switching element SW4, the references of both the sixth voltage V6 and the eighth voltage V8 are the same by the fourth switching element SW4 (as the internal resistance of the fourth switching element SW4 is very small). Both the sixth voltage V6 and the eighth voltage V8 are connected to the first terminal of the second battery string 200, if the sensors for measuring the sixth voltage V6 and the eighth voltage V8 are functional, both the sixth voltage V6 and the eighth voltage V8 may be equal to the voltage across the second battery string 200. If any of the sensor for measuring the sixth voltage V6 and the eighth voltage V8 is broken, the sixth voltage V6 and the eighth voltage V8 may be different or may not equal to voltage across the second battery string 200. The control unit may compare the sixth voltage V6 and the eighth voltage V8.

The method may comprise after determining both sensors are functional, controlling the fourth switching element SW4 to open. Then, the step of determining the status of the fourth switching element SW4 may be performed.

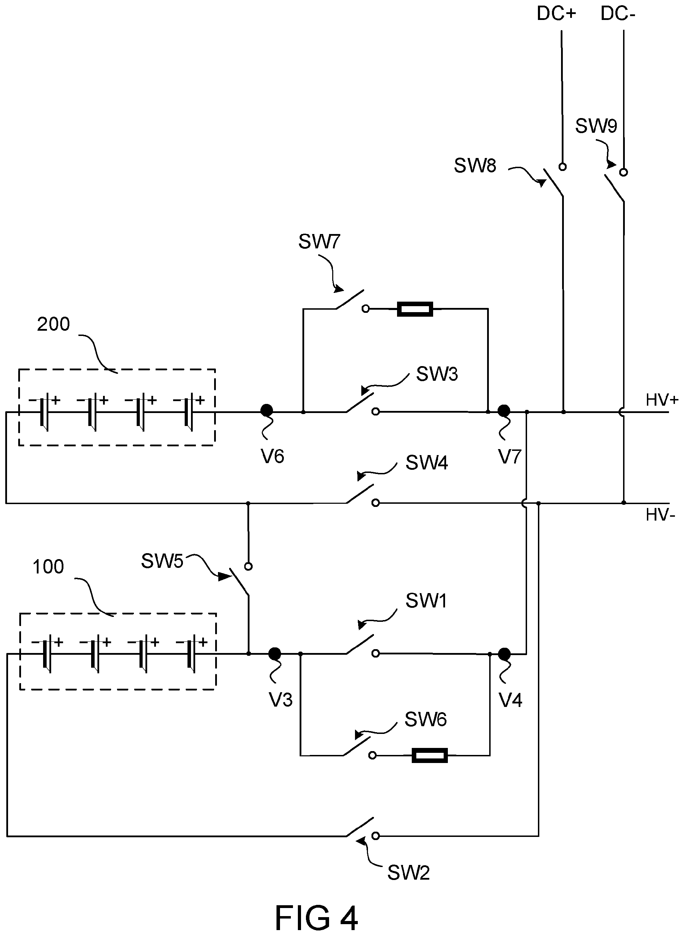

Fig. 4 is an example schematic circuit diagram of a battery pack comprising a pre-charge circuit. In connection with fig. 4, the pre-charge circuit will be discussed in more detail.

A pre-charge circuit may be used to prevent stress and damage to a high voltage (e.g., above 100 V) electric system by limiting inrush current. High inrush current may lead to fuse melting or welded contacts of the switching elements. A pre-charge circuit may further reduce the risk of switching elements being stuck closed or overheat of the battery pack.

In fig. 4, the battery pack may comprise a first pre-charge circuit, configured to be electrically connected in parallel to the first switching element SW1. The first pre-charge circuit may comprise a sixth switching element SW6. The first pre-charge circuit may comprise a resistor connected in series with the sixth switching element SW6.

The first pre-charge circuit may be connected in parallel to the first switching element SW1 such that a first terminal of the sixth switching element SW6 may be connected to the first terminal of the first switching element SW1, and a second terminal of the sixth switching element SW6 may be connected to the second terminal of the first switching element SW1.

When the resistor is connected in series with the sixth switching element SW6 as shown in fig. 4, the second terminal of the sixth switching element SW6 may be connected to a first terminal of the resistor, and a second terminal of the resistor may be further connected to the second terminal of the first switching element SW1.

The first terminal of the sixth switching element SW6 may have the same electric potential as the first terminal of the first switching element SW1.

The step of determining a status of the plurality of switching elements being open or closed may further comprise determining a status of the sixth switching element SW6 being open or closed, e.g., based on the voltage V3 and V4 (the same as those shown in fig. 3).

The method may comprise measuring the third voltage V3 on the one terminal of the first switching element SW1 connected to the first battery string 100, by using the second terminal of the first battery string 100 as a reference.

Since the sixth switching element SW6 is electrically connected in parallel with the first switching element SW1, the third voltage V3 may present the voltage of the first terminal of the sixth switching element SW6.

The method may comprise measuring the fourth voltage V4 on the another terminal of the first switching element SW1 connected to the first node HV+, by using the second terminal of the first battery string 100 as a reference.

Upon determination of the third voltage V3 being equal to a voltage across the first battery string 100, and the fourth voltage V4 being not equal to the voltage across the first battery string 100, determining the status of the both the sixth switching element SW6 and the first switching element SW1 being open, otherwise, determining the status of the sixth switching element SW6 being closed.

When the first pre-charge circuit comprises a resistor connected in series with the sixth switching element SW6, and when there is a current through the first pre-charge circuit, the resistor will cause a voltage drop. The voltage drop may be taken into account when comparing the voltages V3 and V4 for determining the status of the sixth switching element SW6.

The voltage drop may be determined based on the current through the first pre-charge circuit and the resistance of the resistor.

When the first pre-charge circuit does not comprise any components, which would cause any voltage changes, the voltages V3 and V4 may be determined to be equal, when an absolute difference between the third and fourth voltages V3 and V4 is zero, or equal to or less than a threshold; and the third and fourth voltages V3 and V4 may be determined not to be equal, when an absolute difference between the third and fourth voltages V3 and V4 is not zero, or larger than the threshold.

The threshold may be 50 V, preferably 20 V, most preferably 5 V.

Alternatively, or in combination, the threshold may be 50%, preferably 20%, most preferably 5%, of any one of the third and fourth voltages V3 and V4.

When the first pre-charge circuit does comprise a component, such as a resistor as shown in fig. 4, which would cause a voltage drop, the third and fourth voltages V3 and V4 may be determined to be equal, when an absolute difference between the third and fourth voltages V3 and V4 is equal to the voltage drop, or equal to or less than a sum of the threshold and the voltage drop. The third and fourth voltages V3 and V4 may be determined not to be equal, when an absolute difference between the third and fourth voltages V3 and V4 is not equal to the voltage drop, or larger than a sum of the threshold and the voltage drop.

The threshold may be 50 V, preferably 20 V, most preferably 5 V.

For example, when the third voltage V3 is 400 V, and the fourth voltage V4 is 300 V, and the voltage drop caused by the resistor connected in series with the sixth switching element SW6 is 20 V. The absolute difference between the third voltage V3 and the fourth voltage V4 (100 V) is larger than to a sum of the threshold (50 V) and the voltage drop (20 V). The third voltage V3 and the fourth voltage V4 may be determined not to be equal. The status of the sixth switching element SW6 may be determined to be open.

Alternatively, or in combination, the threshold may be 50 %, preferably 20 %, most preferably 5%, of any one of the third and fourth voltages V3 and V4.

When the sixth switching element SW6 is open and the first switching element SW1 is open, the electric potentials of the two terminals of the sixth switching element SW6 may be different, since the conducting path between the measuring points of the third voltage V3 and fourth voltage V4 are disconnected by the first and sixth switching elements SW1, SW6 being open. Thus, it may determine the status of the both the sixth switching element SW6 and the first switching element SW1 being open, when the third and fourth voltages V3, V4 are different and the third voltage V3 is equal to the voltage of the first battery string 100.

When the status of each of the plurality of switching elements is open, the method may comprise when the fifth switching element SW5 is controlled to close, preventing any of the first, fourth and sixth switching elements SW1, SW4, SW6 from being closed, until determining the status of each of the plurality of switching elements being open. When any of the first, fourth and sixth switching elements SW1, SW4, SW6 is controlled to close, preventing the fifth switching element SW5 from being closed, until determining the status of each of the plurality of switching elements being open.

By preventing combinations of certain switching elements being closed at the same time, the risk of short-circuit of the battery pack may be reduced.

The method may comprise upon determination of the status of the sixth switching element SW6 being closed, outputting a result indicating a failure of the sixth switching element SW6 being stuck closed.

The method may comprise upon determination of the status of the sixth switching element SW6 being closed, disconnecting the battery pack from the first and second nodes HV+, HV-.

The battery pack may comprise a second pre-charge circuit, configured to be electrically connected in parallel to the third switching element SW3, as shown in fig. 4. The second pre-charge circuit may comprise a seventh switching element SW7. The second pre-charge circuit may comprise a resistor connected in series with the seventh switching element SW7.

The second pre-charge circuit is connected in parallel to the third switching element SW3 such that a first terminal of the seventh switching element SW7 may be connected to the first terminal of the third switching element SW3, and a second terminal of the seventh switching element SW7 may be connected to the second terminal of the third switching element SW3.

When the resistor is connected in series with the seventh switching element SW7 as shown in fig. 4, the second terminal of the seventh switching element SW7 may be connected to a first terminal of the resistor, and a second terminal of the resistor may be further connected to the second terminal of the third switching element SW3.

The first terminal of the seventh switching element SW7 may have the same electric potential as the first terminal of the third switching element SW3.

The step of determining a status of the plurality of switching elements being open or closed may further comprise determining a status of the seventh switching element SW7 being open or closed, e.g., based on the voltage V6 and V7 (the same as those shown in fig. 3).

The method may comprise measuring the sixth voltage V6 on the one terminal of the third switching element SW3 connected to the second battery string 200, by using the second terminal of the second battery string 200 as a reference.

Since the seventh switching element SW7 is electrically connected in parallel with the third switching element SW3, the sixth voltage V6 may present the voltage of the first terminal of the seventh switching element SW7.

The method may comprise measuring the seventh voltage V7 on the another terminal of the third switching element SW3 connected to the first node HV+, by using the second terminal of the second battery string 200 as a reference.

Upon determination of the sixth voltage V6 being equal to a voltage across the second battery string 200, and the seventh voltage V7 being not equal to the voltage across the second battery string 200, determining the status of the both the seventh switching element SW7 and the third switching element SW3 being open, otherwise, determining the status of the seventh switching element SW7 being closed.

When the second pre-charge circuit comprises a resistor connected in series with the seventh switching element SW7, and when there is a current through the second pre-charge circuit, the resistor will cause a voltage drop. The voltage drop may be taken into account when comparing the sixth and seventh voltages V6 and V7 for determining the status of the seventh switching element SW7.

The voltage drop may be determined based on the current through the first pre-charge circuit and the resistance of the resistor.

When the second pre-charge circuit does not comprise any components, which would cause any voltage changes, the sixth and seventh voltages V6 and V7 may be determined to be equal, when an absolute difference between the sixth and seventh voltages V6 and V7 is zero, or equal to or less than a threshold; and the sixth and seventh voltages V6 and V7 may be determined not to be equal, when an absolute difference between the sixth and seventh voltages V6 and V7 is not zero, or larger than the threshold.

The threshold may be 50 V, preferably 20 V, most preferably 5 V.

Alternatively, or in combination, the threshold may be 50 %, preferably 20 %, most preferably 5%, of any one of the two voltages.

When the second pre-charge circuit does comprise a component, such as a resistor, which would cause a voltage drop, the voltages V6 and V7 may be determined to be equal, when an absolute difference between the voltages V6 and V7 is equal to the voltage drop, or equal to or less than a sum of the threshold and the voltage drop. The voltages V6 and V7 may be determined not to be equal, when an absolute difference between the two voltages is not equal to the voltage drop, or larger than a sum of the threshold and the voltage drop.

The threshold may be 50 V, preferably 20 V, most preferably 5 V.

For example, when the sixth voltage V6 is 400 V, and the seventh voltage V7 is 300 V, and the voltage drop caused by the resistor connected in series with the seventh switching element SW7 is 20 V. The absolute difference between the sixth voltage V6 and the seventh voltage V7 (100 V) is larger than to a sum of the threshold (50 V) and the voltage drop (20 V). The sixth voltage V6 and the seventh voltage V7 may be determined not to be equal. The status of seventh switching element SW7 may be determined to be open.

Alternatively, or in combination, the threshold may be 50 %, preferably 20 %, most preferably 5%, of any one of the two voltages.

When the seventh switching element SW7 is open and the third switching element SW3 is open, the electric potentials of the two terminals of the seventh switching element SW7 may be different, since the conducting path between the measuring points of the sixth voltage V6 and seventh voltage V7 are disconnected by the third and seventh switching elements SW3, SW7 being open. Thus, it may determine the status of the both the seventh switching element SW7 and the third switching element SW3 being open, when the sixth and seventh voltages V6, V7 are different and the sixth voltage V6 is equal to the voltage of the second battery string 200.

The method may comprise upon determination of the status of the seventh switching element SW7 being closed, outputting a result indicating a failure of the seventh switching element SW7 being stuck closed.

The method may comprise upon determination of the status of the seventh switching element SW7 being closed, disconnecting the battery pack from the first and second nodes HV+, HV-.

The method may comprise checking whether the plurality of sensors for measuring the voltages for determining the status of the sixth and the seventh switching elements SW6, SW7 being functional.

Since the status of the sixth and the seventh switching elements SW6, SW7 may be determined by using the same voltages (V3, V4, V6, V7) as for the first and third switching elements SW1, SW3. There is no need to add additional sensors for the sake of the sixth and the seventh switching elements SW6, SW7, no matter whether the first and second pre-charge circuit comprising any components, which would cause a voltage drop, in addition to the sixth and seventh switching elements SW6, SW7 or not, respectively.

In fig. 4, the battery pack may comprise a first and second DC terminals DC+, DC-, respectively connected to the first and second nodes HV+, HV-. An eighth switching element SW8 may be configured to be electrically connected between the first node HV+ and the first DC terminal DC+. A nineth switching element SW9 may be configured to be electrically connected between the second node HV- and the second DC terminal DC-.

When both the switching elements SW8 and SW9 are closed, the voltage across the first and second nodes HV+ and HV- may be the same as the voltage across the first and second DC terminals DC+, DC-.

The status of the eighth and nineth switching elements SW8, SW9 may be open when the battery pack is not connected to a charging station. The eighth switching element SW8 and the nineth switching element SW9 may be controlled to open after determining a charging process is completed or when a charging process is aborted (e.g., disconnected from the charging station before the charging process is completed). Determining the status of each of the eighth and nineth switching element SW8, SW9 may be performed when the other switching elements (e.g., the first to the seventh switching elements, SW1 to SW7 are determined to be open), and after a charging process is completed or aborted.

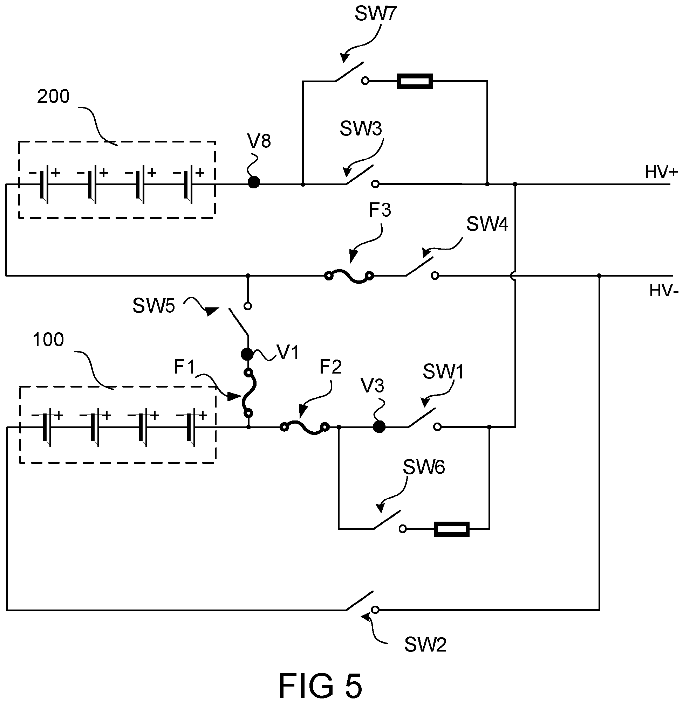

Fig. 5 is an example schematic circuit diagram of a battery pack comprising a fuse. In connection with fig. 5, the fuse will be discussed in more detail.

A fuse may be an electrical safety device for providing an overcurrent protection of an electrical circuit. Typically, the fuse comprises a metal wire or strip that melts when too much current flows through it, such that the current can be stopped and/or interrupted to avoid the current damaging the electrical circuit. In other words, the fuse may be a sacrificial device. Once a fuse has operated, it will cause an open circuit, and the fuse must be replaced or rewired.

The battery pack may comprise a first fuse F1 configured to be electrically connected between the first terminal of first battery string 100 and the first terminal of the fifth switching element SW5. The first voltage V1 may be measured at a measuring point between the first fuse F1 and the fifth switching element SW5.

The battery pack may comprise a second fuse F2 configured to be electrically connected between the first terminal of first battery string 100 and the first terminal of first switching element SW1. The third voltage V3 may be measured at a measuring point between the second fuse F2 and the first switching element SW1.

The battery pack may comprise a third fuse F3 configured to be electrically connected between the second terminal of the second battery string 200 and the first terminal of the fourth switching element SW4.

The fuses of the batter pack may be any type of fuse suitable, e.g., a smart fuse and/or a battery fuse.

There may be provided a method for determining a status of the fuses F1, F2, F3, e.g., intact or melt.

The method of checking whether the plurality of fuses is intact or melt, may be the step prior to the step of determining a status of the plurality of switching elements being open or closed.

The fuse being intact may be understood as the fuse is able to provide safety protection (e.g., not melting). When the fuse is intact, it may provide a conducting path in the circuit and allow the current to pass through. The fuse being intact may cause a very small voltage drop as the resistance of the fuse is very small. When the fuse is intact, this voltage drop may be ignored such that the voltages measured on both terminals of the fuses may be considered to be equal.

The fuse being broken may be understood as the fuse is melt. It may create an open circuit and not allow the current to pass through.

A broken fuse of the battery pack may cause an open circuit, which will influence the voltages measured for determining the status of the switching elements, e.g., a zero Volt may be measure on both terminals of one switching element, which may lead to an incorrect determination of the status of one or more switching elements. Thus, checking whether the plurality of fuses is intact or broken may be performed prior to the determination of the status of the switching elements.

For example, if the fifth switching element SW5 is open, but the first fuse F1 in the conducting path is broken/melt, the melt fuse F1 may create an open circuit in the conducting path. Consequently, the first voltage V1 may be the potential between the open fifth switching element SW5 and the first fuse F1, so the first voltage V1 may be zero.

The status of the first fuse F1 may be determined by comparing voltage the first voltage V1 with the voltage across the first battery string 100. The method may comprise upon determination of the first voltage V1 being equal to the voltage across the first battery string 100, determining the status of the first fuse F1 being intact. Otherwise, it may determine the status of first fuse F1 being broken.

It may be beneficial for checking status of the first fuse F1 prior to determining the status of the fifth switching element SW5. For example, when the first fuse F1 is broken, the measured voltages may wrongly indicate that the fifth switching element SW5 being open, no matter the fifth switching element SW5 is open or closed. Thus, by determining the status of the first fuse F1, it may further improve the safety of the battery pack.

The status of the second fuse F2 may be determined by comparing the voltage third voltage V3 with the voltage across the first battery string 100.

The method may comprise controlling the plurality of switching elements SW1, SW2, ... to open prior to determining the status of the second fuse F2.

When the first and second battery strings 100, 200 are connected in parallel, e.g. when the first and/or the sixth SW1, SW6, the third and/or the seventh SW3, SW7, the second and the fourth switching SW2, SW4 elements are closed, and when the voltages across the first and second battery strings 100, 200 are the same voltage, and the third fuse F3 is intact, the third voltage V3 may be equal to the voltage across the second battery string 200, which may be the same voltage value as the voltage across the first battery string 100, even if the second fuse F2 is broken. Thus, the status of the second fuse F2 cannot be correctly determined.

By controlling the plurality of switching elements to open, the third voltage V3 may not be equal to the voltage across the first battery string 100 or across the second battery string 200, if the second fuse F2 is not intact. Thus, the status of the second fuse F2 may be corrected determined.

The method may comprise upon determination of the third voltage V3 being equal to the voltage across the first battery string 100, determining the second fuse F2 being intact. Otherwise, the status of the second fuse F2 is determined to be broken.

The status of the third fuse F3 may be determined by comparing voltage the eighth voltage V8 with the voltage across the second battery string 200.

The eight voltage V8 may be the same as it used for determining the status for the fourth switching element SW4, which is described in connection with fig. 3.

The eighth voltage V8 may be an electric potential measured at a first terminal of the third switching element SW3 connected with the first terminal of the second battery string 200, using the second node HV- as a reference. That is, the eighth voltage V8 is an electric potential difference between the first terminal of the second battery string 200 and the second node HV-through the third fuse F3.

The method may comprise controlling the plurality of switching elements SW1, SW2, SW3, ... to open prior to determining the status of the second fuse F3.

By controlling the plurality of switching elements to open, the eighth voltage V8 may not be equal to the voltage across the first battery string 100 or across the second battery string 200, if the third fuse F3 is not intact. Thus, the status of the third fuse F3 may be corrected determined.

The method may comprise upon determination of the sixth voltage V6 being equal to the voltage across the second battery string 200, determining the third fuse F3 being intact. Otherwise, the status of the third fuse F3 is determined to be broken.

The person skilled in the art realizes that the present invention by no means is limited to the examples described above. On the contrary, many modifications and variations are possible within the scope of the appended claims. For example, the switching element may be of different types, and the battery pack may comprise additional components. Such details are not considered to be an important part of the invention, which relates to the control method of a battery pack.

## Claims

1. A control method of a battery pack, wherein the battery pack comprises:
a first node (HV+) and a second node (HV-),
a first battery string (100) and a second battery string (200), configured to be electrically connected in series or parallel for collectively charging or outputting power via the first and second nodes (HV+, HV-),
a plurality of switching elements each comprising two terminals, comprising:
a first switching element (SW1), electrically connected between a first terminal of the first battery string (100) and the first node (HV+),
a second switching element (SW2), electrically connected between a second terminal of the first battery string (100) and the second node (HV-),
a third switching element (SW3), electrically connected between a first terminal of the second battery string (200) and the first node (HV+),
a fourth switching element (SW4), electrically connected between a second terminal of the second battery string (200) and the second node (HV-), and
a fifth switching element (SW5), electrically connected between the first terminal of the first battery string (100) and the second terminal of the second battery string (200);
wherein when the second, third and fifth switching elements (SW2, SW3, SW5) are closed, the first and second battery strings (100, 200) are configured to be electrically connected in series between the first and second nodes;
when the first, second, third and fourth switching elements (SW1, SW2, SW3, SW4) are closed, the first and second battery strings (100, 200) are configured to be electrically connected in parallel between the first and second nodes;
the method comprising:
controlling the plurality of switching elements to open;
providing a plurality of sensors and the plurality of sensors measuring a respective voltage value on each terminal of each of the plurality of switching elements;
determining a status of each of the plurality of switching elements being open or closed, based on the measured voltage values;
upon determination of the status of each of the plurality of switching elements being open, the method comprising:
when the fifth switching element (SW5) is controlled to close, preventing any of the first and fourth switching elements (SW1, SW4) from being closed, until determining the status of each of the plurality of switching elements being open; and
when any of the first and fourth switching elements (SW1, SW4) is controlled to close, preventing the fifth switching element (SW5) from being closed, until determining the status of each of the plurality of switching elements being open.

2. The method of claim 1, wherein the step of determining a status of the plurality of switching elements being open or closed, comprises:
determining the status of the fifth switching element (SW5), comprising:
measuring a first voltage (V1) on one terminal of the fifth switching element (SW5) connected to the first battery string (100), by using the second terminal of the first battery string (100) as a reference,
measuring a second voltage (V2) on another terminal of the fifth switching element (SW5) connected to the second battery string (200), by using the second terminal of the first battery string (100) as a reference,
upon determination of the first voltage (V1) being equal to a voltage across the first battery string (100), and the second voltage (V2) being not equal to the voltage across the first battery string (100), determining the status of the fifth switching element (SW5) being open,
otherwise, determining the status of the fifth switching element (SW5) being closed.

3. The method of any of claims 1-2, wherein the step of determining a status of the plurality of switching elements being open or closed, comprises:
determining the status of the first switching element (SW1), comprising:
measuring a third voltage (V3) on one terminal of the first switching element (SW1) connected to the first battery string (100), by using the second terminal of the first battery string (100) as a reference,
measuring a fourth voltage (V4) on another terminal of the first switching element (SW1) connected to the first node (HV+), by using the second terminal of the first battery string (100) as a reference,
upon determination of the third voltage (V3) being equal to a voltage across the first battery string (100), and the fourth voltage (V4) being not equal to the voltage across the first battery string (100), determining the status of the first switching element (SW1) being open,
otherwise, determining the status of the first switching element (SW1) being closed.

4. The method of any of claims 1- 3, wherein the step of determining a status of the plurality of switching elements being open or closed, comprises:
determining the status of the second switching element (SW2), comprising:
measuring a third voltage (V3) on one terminal of the first switching element (SW1) connected to the first battery string (100), by using the second terminal of the first battery string (100) as a reference,
measuring a fifth voltage (V5) on said one terminal of the first switching element (SW1) connected to the first battery string (100), by using the second node (HV-) as a reference,
upon determination of the third voltage (V3) being equal to a voltage across the first battery string (100), and the fifth voltage (V5) being not equal to the voltage across the first battery string (100), determining the status of the second switching element (SW2) being open,
otherwise, determining the status of the second switching element (SW2) being closed.

5. The method of any of claims 1-4, wherein the step of determining a status of the plurality of switching elements being open or closed, comprises:
determining the status of the third switching element (SW3), comprising:
measuring a sixth voltage (V6) on one terminal of the third switching element (SW3) connected to the second battery string (200), by using the second terminal of the second battery string (200) as a reference,
measuring a seventh voltage (V7) on another terminal of the third switching element connected to the first node (HV+), by using the second terminal of the second battery string (200) as a reference,
upon determination of the sixth voltage (V6) being equal to a voltage across the second battery string (200), and the seventh voltage (V7) being not equal to the voltage across the second battery string (200), determining the status of the third switching element (SW3) being open,
otherwise, determining the status of the third switching element (SW3) being closed.

6. The method of any of claims 1- 5, wherein the step of determining a status of the plurality of switching elements being open or closed, comprises:
determining the status of the fourth switching element (SW4), comprising:
measuring a sixth voltage (V6) on one terminal of the third switching element (SW3) connected to the second battery string (200), by using the second terminal of the second battery string (200) as a reference,
measuring an eighth voltage (V8) on said one terminal of the third switching element (SW3) connected to the second battery string (200), by using the second node (HV-) as a reference,
upon determination of the sixth voltage (V6) being equal to a voltage across the second battery string (200), and the eighth voltage (V8) being not equal to the voltage across the second battery string (200), determining the status of the fourth switching element (SW4) being open,
otherwise, determining the status of the fourth switching element (SW4) being closed.

7. The method of any of claims 1-6, wherein the battery pack comprises a first pre-charge circuit, configured to be electrically connected in parallel to the first switching element (SW1);
wherein the first pre-charge circuit comprises a sixth switching element (SW6);
when the status of each of the plurality of switching elements is open, the method comprising:
when the fifth switching element (SW5) is controlled to close, preventing any of the first, fourth and sixth switching elements (SW1, SW4, SW6) from being closed, until determining the status of each of the plurality of switching elements being open;
when any of the first, fourth and sixth switching elements (SW1, SW4, SW6) is controlled to close, preventing the fifth switching element (SW5) from being closed, until determining the status of each of the plurality of switching elements being open.

8. The method of claim 7, wherein the step of determining a status of the plurality of switching elements being open or closed, comprises:
determining the status of the sixth switching element (SW6), comprising:
measuring a third voltage (V3) on one terminal of the first switching element (SW1) connected to the first battery string (100), by using the second terminal of the first battery string (100) as a reference,
measuring a fourth voltage (V4) on another terminal of the first switching element (SW1) connected to the first node (HV+), by using the second terminal of the first battery string (100) as a reference,
upon determination of the third voltage (V3) being equal to a voltage across the first battery string (100), and the fourth voltage (V4) being not equal to the voltage across the first battery string (100), determining the status of the sixth switching element (SW6) being open,
otherwise, determining the status of the sixth switching element (SW6) being closed.

9. The method of any of claims 1- 8, wherein the battery pack comprises a second pre-charge circuit, configured to be electrically connected in parallel to the third switching element (SW3);
wherein the second pre-charge circuit comprises a seventh switching element (SW7);
wherein the step of determining a status of the plurality of switching elements being open or closed, comprises:
determining the status of the seventh switching element (SW7), comprising:
measuring a sixth voltage (V6) on one terminal of the third switching element (SW3) connected to the second battery string (200), by using the second terminal of the second battery string (200) as a reference,
measuring a seventh voltage (V7) on another terminal of the third switching element (SW3) connected to the first node (HV+), by using the second terminal of the second battery string (200) as a reference,
upon determination of the sixth voltage (V6) being equal to a voltage across the second battery string (200), and the seventh voltage (V7) being not equal to the voltage across the second battery string (200), determining the status of the seventh switching element (SW7) being open,
otherwise, determining the status of the seventh switching element (SW7) being closed.

10. The method of any of claims 1- 9, wherein the method comprises:
upon determination of the status of each of the plurality of switching elements being open, initiating a process of the battery pack which causes a change of voltage between the first and second nodes (HV+, HV-).

11. The method of any of claims 1- 10, comprises:
checking whether the plurality of sensors is functional, prior to the step of determining a status of the plurality of switching elements being open or closed.

12. The method of claim 11, wherein the step of checking whether the plurality of sensors is functional comprises:
when depending on claim 2,
controlling the fifth switching element (SW5) to close,
measuring the first voltage (V1) and the second voltage (V2),
upon determination of both the first voltage (V1) and the second voltage (V2) being equal to the voltage across the first battery string (100), determining sensors for measuring the first and second voltages (V1, V2) being functional, and
controlling the fifth switching element (SW5) to open;
when depending on claim 3,
controlling the first switching element (SW1) to close,
measuring the third voltage (V3) and the fourth voltage (V4),
upon determination of both the third voltage (V3) and the fourth voltage (V4) being equal to the voltage across the first battery string (100), determining sensors for measuring the third and fourth voltages (V3, V4) being functional, and
controlling the first switching element (SW1) to open;
when depending on claim 4,
controlling the second switching element (SW2) to close,
measuring the third voltage (V3) and the fifth voltage (V5),
upon determination of both the third voltage (V3) and the fifth voltage (V5) being equal to the voltage across the first battery string (100), determining sensors for measuring the third and fifth voltages (V3, V5) being functional, and
controlling the second switching element (SW2) to open;
when depending on claim 5,
controlling the third switching element (SW3) to close,
measuring the sixth voltage (V6) and the seventh voltage (V7),
upon determination of both the sixth voltage (V6) and the seventh voltage (V7) being equal to the voltage across the second battery string (200), determining sensors for measuring the sixth and seventh voltages (V6, V7) being functional, and
controlling the third switching element (SW3) to open;
when depending on claim 6,
controlling the fourth switching element (SW4) to close,
measuring the sixth voltage (V6) and the eighth voltage (V8),
upon determination of both the sixth voltage (V6) and the eighth voltage (V8) being equal to the voltage across the second battery string (200), determining sensors for measuring the sixth and eighth voltages (V6, V8) being functional, and
controlling the fourth switching element (SW4) to open;
when depending on claim 8,
controlling the sixth switching element (SW6) to close,
measuring the third voltage (V3) and the fourth voltage (V4),
upon determination of both the third voltage (V3) and the fourth voltage (V4) being equal to the voltage across the first battery string (100), determining sensors for measuring the third and fourth voltages (V3, V4) being functional, and
controlling the sixth switching element (SW6) to open; and
when depending on claim 9,
controlling the seventh switching element (SW7) to close,
measuring the sixth voltage (V6) and the seventh voltage (V7),
upon determination of both the sixth voltage (V6) and the seventh voltage (V7) being equal to the voltage across the second battery string (200), determining sensors for measuring the sixth and seventh voltages (V6, V7) being functional, and
controlling the seventh switching element (SW7) to open.

13. The method of any of claims 1- 12, wherein any of the switching elements is a contactor or a relay.

14. A battery pack control system of a battery pack,
wherein the battery pack comprises:
a first node (HV+) and a second node (HV-),
a first battery string (100) and a second battery string (200), configured to be electrically connected in series or parallel for collectively charging or outputting power via the first and second nodes (HV+, HV-),
a plurality of switching elements each comprising two terminals, comprising:
a first switching element (SW1), electrically connected between a first terminal of the first battery string (100) and the first node (HV+),
a second switching element (SW2), electrically connected between a second terminal of the first battery string (100) and the second node (HV-),
a third switching element (SW3), electrically connected between a first terminal of the second battery string (200) and the first node (HV+),
a fourth switching element (SW4), electrically connected between a second terminal of the second battery string (200) and the second node (HV-), and
a fifth switching element (SW5), electrically connected between the first terminal of the first battery string (100) and the second terminal of the second battery string (200);
wherein when the second, third and fifth switching elements (SW2, SW3, SW5) are closed, the first and second battery strings (100, 200) are configured to be electrically connected in series between the first and second nodes (HV+, HV-);
when the first, second, third and fourth switching elements (SW1, SW2, SW3, SW4) are closed, the first and second battery strings (100, 200) are configured to be electrically connected in parallel between the first and second nodes (HV+, HV-);
wherein the battery pack control system comprises a control unit and a plurality of sensors;
wherein the control unit is configured to control the plurality of switching elements to open;
wherein the plurality of sensors is configured to measure a respective voltage value on each terminal of each of the plurality of switching elements;
wherein the control unit is configured to:
determine a status of each of the plurality of switching elements being open or closed, based on the measured voltage values;
wherein, upon determination of the status of each of the plurality of switching elements being open, the control unit is configured to:
when the fifth switching element (SW5) is controlled to close, prevent any of the first and fourth switching elements (SW1, SW4) from being closed, until determining the status of each of the plurality of switching elements being open; and
when any of the first and fourth switching elements (SW1, SW4) is controlled to close, prevent the fifth switching element (SW5) from being closed, until determining of the status of each of the plurality of switching elements being open.

15. An electric vehicle or a hybrid electric vehicle comprising the battery pack control system of claim 14.
